# EUROPÄISCHE PATENTSCHRIFT

(11) **EP 3 907 517 B1**
(45) Veröffentlichungstag und Bekanntmachung des Hinweises auf die Patenterteilung: **23.10.2024**
(21) Anmeldenummer: 21171444.9
(22) Anmeldetag: 30.04.2021
(51) Int. Cl.: G01R 31/52, H02H 3/16, H02H 1/04, H02H 3/33, H02H 9/00

(54) **VERFAHREN UND SCHALTUNGSANORDNUNG ZUM BETREIBEN EINES EMV-FILTERS**
METHOD AND SWITCHING ASSEMBLY FOR OPERATING AN EMC FILTER
PROCÉDÉ ET AGENCEMENT DE COMMUTATION PERMETTANT DE FAIRE FONCTIONNER UN FILTRE CEM

(30) Priorität: 30.04.2020 DE 102020111894
(43) Veröffentlichungstag der Anmeldung: 10.11.2021
(73) Patentinhaber: EPA GmbH, 63486 Bruchköbel (DE)
(72) Erfinder: DIENERSBERGER, Wolfgang, 81925 München (DE)
(74) Vertreter: Stoffregen, Hans-Herbert

(56) Entgegenhaltungen:
- DE-A1- 102011 076 877
- DE-A1- 19 509 658
- GRUNEBAST GUNTER: "Kein Problem: RCD vor Freqeunzumrichter (1)", ELECTROINSTALLATION, vol. 10, 1 January 2007 (2007-01-01), pages 26 - 29, XP055807984, Retrieved from the Internet <URL:http://toolbox.electrosuisse.ch/_files/downloads/RCD_vor_Frequenzumrichter_de_Fachbericht.pdf>

## Beschreibung

Die Erfindung betrifft ein Verfahren zum Betreiben eines EMV-Filters an einem Phasenspannungen aufweisenden Mehrphasenstromnetz nach dem Oberbegriff des Anspruchs 1 sowie eine Schaltungsanordnung zum Betreiben eines EMV-Filters nach dem Oberbegriff des Anspruchs 11.

Die DE 10 2011 076 877 A1 betrifft eine Vorrichtung zur Verbesserung der Filterwirkung eines zwischen einer elektrischen Energiequelle und einer Störquelle verschalteten Filters. Das Filter ist ausgebildet, um Störtransienten aus der Erde in den Eingang der die Störtransiente erzeugenden Störquelle zurückzuführen. Die offenbarte Vorrichtung umfasst eine Messeinrichtung zum Ermitteln eines durch den Filter fließenden Fehlerstroms und eine Stelleinrichtung, die ausgebildet ist, eine Grenzfrequenz des Filters derart zu verändern, dass der Fehlerstrom durch den Filter unter einen vorbestimmten Pegel gedämpft wird, wenn die Messeinrichtung den Fehlerstrom erfasst.

Offenbart ist zudem ein Netzwerk mit einer Netzfilterschaltung, die durch eine Messvorrichtung gesteuert wird. In dem Netzwerk wird eine Last über drei Phasen aus einer dreiphasigen elektrischen Energiequelle versorgt. Auf den Phasen sind das durch die Messvorrichtung gesteuerte Filter sowie ein ungesteuertes Filter angeordnet, die Erdableitströme aus der Erde in den Eingang eines nicht gezeigten elektrischen Wandlers zurückleiten können.

Derartige Erdableitströme können durch das gesteuerte Filter gefiltert werden. Das gesteuerte Filter weist einen Schalter sowie drei Kapazitäten auf, über die die drei Phasen zu einer Sternschaltung verschaltet sind. Über Kapazitäten können somit Gegentaktstörungen gefiltert werden, so dass die Kapazitäten wie X-Kapazitäten wirken.

Wird der Sternpunkt des gesteuerten Filters über den Schalter mit der Erde verbunden, so können die Kapazitäten auch Gleichtaktstörungen erden, so dass sie wie XY-Kapazitäten wirken. Der Schalter wird durch die Messvorrichtung über ein Relais gesteuert, die einen Fehlerstrom durch die Kapazitäten zur Erde erfasst und prüft, ob dieser zu hoch ist. Ist dies der Fall kann die Messvorrichtung das gesteuerte Filter von der Erde trennen. Das Problem einer Fehlauslösung eines Fehlerstromschutzschalters durch Ausgleichströme des EMV-Filters bei einer Asymmetrie der Phasenspannungen ist in der DE 10 2011 076 877 A1 nicht angesprochen.

Die DE 101 56 198 A1 betrifft ein Filter zur Vermeidung einer Netz-Rückwirkung in Form elektrischer Störsignale und ein Verfahren zum Betreiben eines Funkstörungsfilters, das mit einem Umrichter verbunden ist. Es werden Funkstörungsfilter mit Umrichter verbunden, um Funkstörsignale, die über Leitungen übertragen werden, zu verringern. Diese Filter weisen große Störsignalableitkondensatoren auf, die mit Erde verbunden sind, und während der Anlaufphase des Umrichters leiten diese Kondensatoren Erdschlussströme zur Erde ab. Dadurch ergeben sich Probleme, wenn ein Trennschalter mit einem Umrichter und einem Funkstörungsfilter verbunden ist, weil der Erdschlussstrom größer als der Auslösestrom des Trennschalters sein kann. Zur Lösung wird die Anordnung eines ohmschen Widerstands in Reihe mit dem Störsignalableitkondensator und parallel zu diesem Widerstand die Anordnung eines Schalters vorgeschlagen, der durch ein Steuersignal einer Steuereinrichtung geöffnet oder geschlossen werden kann.

Die Aufsätze von G. Grünebast: "Kein Problem: RCD vor Frequenzumrichter (1)", Elektroinstallation, DE 10/2007, S. 26 - 29 sowie "Kein Problem: RCD vor Frequenzumrichter (2)", Elektroinstallation, DE 11/2007, S. 38 - 40, betreffen den Einsatz von Fehlerstromschutzeinrichtungen (RCD), die vor Frequenzumrichtern angeordnet sind. Zur Einhaltung einschlägiger Norm-Vorschriften darf ein Frequenzumrichter nur über ein vorgeschaltetes EMV-Filter betrieben werden. Da die pulsweitenmodulierte Ausgangsspannung des Frequenzumrichters äußerst steilflankig ist und somit Oberschwingungen hoher Amplituden und Frequenzen enthält, darf man den Motor, ebenfalls zur Einhaltung der EMV-Vorschriften, nur über eine abgeschirmte Leitung mit dem Frequenzumrichter verbinden. Es wird ausgeführt, dass bei Ausschaltevorgängen im Netz in Folge der Induktivitäten in den Strompfaden Spannungsspitzen auftreten, die auf Grund der hohen steilen Anstiegsflanken sehr hohe Frequenzanteile enthalten (transiente Ableitströme). Auch durch Einschaltungen bei ungünstigen Phasenwinkeln der Netzspannung enthält das Netzspektrum der Netzspannung kurzzeitig Hochfrequenzanteile in Folge des schnellen Spannungsanstiegs. Diese hochfrequenten Spannungsanteile treiben über die Kapazitäten der EMV-Schutzmaßnahmen transiente Ströme zur Erde, die eine unerwünschte Abschaltung von Fehlerstromschutzschaltern bewirken können.

Die DE 195 09 658 A1 betrifft eine Schaltungsanordnung zur Erzeugung eines Netzausfallsignals bei einem Antriebsregelgerät, das aus einem Dreiphasen-Wechselstromnetz gespeist wird. Das Antriebsregelgerät versorgt über einen Gleichspannungszwischenkreis mittels elektrischer Ventile eine oder mehrere Antriebsmaschinen. Bei einer Unterschreitung eines Spannungsschwellwerts im Zwischenkreis wird ein Spannungssignal für die Stillsetzung der Maschinen gebildet. Um mit geringem Aufwand jegliche Art von Netzausfällen sicher erkennen zu können, wird die ungeglättete Ausgangsspannung des Zwischenkreisgleichrichters mit einem oberen Schwellwert und einem unteren Schwellwert verglichen, und bei Unter- bzw. Überschreitung dieser Schwellwerte eine Kippstufe gesetzt bzw. zurückgesetzt, wobei durch das Signal der gesetzten Kippstufe ein retriggerbares, abfallverzögertes Zeitglied angesteuert wird, aus dessen Ausgangssignal als Netzausfallsignal das Steuersignal für die Stillsetzung des Antriebs an Maschinen gebildet wird.

Die DE 10 2018 102 122 A1 betrifft ein Verfahren und eine Schaltungsanordnung zum Betreiben eines EMV-Filters an einem Dreiphasenstromnetz. Beim Betrieb von Maschinen und Anlagen werden häufig Schaltnetzteile und elektronische Antriebe verwendet. Um die gesetzlichen Anforderungen an die elektromagnetische Verträglichkeit (EMV) zu erreichen, sind Filtermaßnahmen gegen elektrische Störungen nötig.

Hierzu werden EMV-Filter eingesetzt. Diese EMV-Filter weisen mit Schutz- und Potentialausgleichsleiter verbundene Funkentstörkondensatoren auf, durch die Ableitströme entstehen. Ein Ableitstrom ist ein elektrischer Strom, der unter üblichen Betriebsbedingungen in einem unerwünschten Strompfad fließt (Internationales elektrotechnisches Wörterbuch - IEV 195-05-15).

Werden in elektrischen Anlagen zum Sach- und Personenschutz Fehlerstromschutzschalter eingesetzt, können die gegen Erd- oder Massepotential abfließenden Ableitströme den Fehlerstromschutzschalter - insbesondere, wenn dieser zum Personenschutz dient - auslösen.

EMV-Filter für Dreiphasenstromnetze umfassen üblicherweise drei Sternpunkt-Kondensatoren, nachfolgend X-Kondensatoren genannt, die jeweils von einem Phasenleiter des Dreiphasenstromnetzes an einen gemeinsamen Sternpunkt geschaltet sind, und einen zwischen dem Sternpunkt und einem Schutzleiter verschalteten Kondensator, nachfolgend Y-Kondensator genannt. Derartige EMV-Filter weisen im stationären Betrieb in der Regel keinen oder nur einen sehr geringen Ableitstrom bei 50 Hz auf.

Der Ableitstrom ergibt sich ausschließlich durch die Toleranz der Kapazitätswerte der X-Kondensatoren der Sternschaltung. Im Idealfall addieren sich die drei Ströme durch die X-Kondensatoren im Sternpunkt zu Null. An dem Y-Kondensator liegt dann kein 50 Hz-Spannungsanteil an, so dass kein 50 Hz-Ableitstrom zum Schutzleiter fließt.

Beim Ein- und Ausschalten des Dreiphasenstromnetzes tritt allerdings das Problem auf, dass die drei Phasenleiter des Dreiphasenstromnetzes mit üblichen Schaltmitteln nicht exakt gleichzeitig zu- oder abgeschaltet werden können. Daher ergibt sich immer eine kurze Zeitspanne, während der nur ein oder zwei Phasenleiter zugeschaltet sind, so dass an dem Sternpunkt eine Wechselspannung anliegt.

Daher fließt durch den Y-Kondensator ein seiner Kapazität proportionaler 50 Hz-Ableitstrom. Dieser kann zu einer Auslösung eines vorgeschalteten FehlerstromSchutzschalters (RCCB) führen, ohne dass ein tatsächlicher Isolationsfehler im Gerät bzw. in der Anlage vorliegt.

Eine gewisse Abhilfe beim Einschalten kann durch ein zeitverzögertes Zuschalten des EMV-Filters erfolgen. Die Grundannahme dabei ist, dass nach Ablauf der Verzögerungszeit alle drei Phasenspannungen stabil anliegen und die Sternspannung, d. h. die Spannung am Sternpunkt, nahe Null liegt. Die Abschaltung der Phasenspannungen wird jedoch hierdurch nicht detektiert. Es kann somit im Ausschaltmoment wieder eine Fehlauslösung des Fehlerstromschutzschalters durch auftretende Ableitströme auftreten.

Davon ausgehend liegt der vorliegenden Erfindung die Aufgabe zugrunde, ein Verfahren und eine Schaltungsanordnung der eingangs genannten Art derart weiterzubilden, dass bei einer Asymmetrie der Phasenspannungen, insbesondere beim Ein- und Ausschalten eines Mehrphasenstromnetzes, eine Fehlauslösung des Fehlerstromschutzschalters durch Ausgleichsströme eines EMV-Filters vermieden wird.

Die Aufgabe wird erfindungsgemäß u. a. durch ein Verfahren mit den Merkmalen des Anspruchs 1 gelöst.

Gemäß der Erfindung ist vorgesehen, dass der zumindest eine den Ableitstrom führende Strompfad des EMV-Filters mittels der Schalteinrichtung innerhalb einer Ausschaltverzögerungszeit dT_av nach Eintritt der Asymmetrie deaktiviert wird, wobei die Ausschaltverzögerungszeit dT_av kürzer als die Auslösezeit T a des Fehlerstromschutzschalters ist.

Das erfindungsgemäße Verfahren ist dazu ausgebildet ein Netzfilter derart zu steuern, dass bei Eintritt einer signifikanten Phasen-Asymmetrie der Netzspannung oder bei An- und Abschaltung des Filters inkl. Verbraucher der Fehlerstromschutzschalter nicht fälschlicherweise auslöst.

Im Gegensatz zum Stand der Technik soll mittels des erfindungsgemäßen Verfahrens nicht entschieden werden, ob die Netzspannungsparameter noch den Voraussetzungen zum einwandfreien Betrieb z. B. eines nachgeschalteten Frequenzumrichters genügen, sondern das erfindungsgemäße Verfahren soll Bedingungen erkennen, die zum Auftreten zu hoher, ausschließlich filterbedingter Ableitströme führen. Diese Ströme werden durch möglichst schnelles Trennen des CY-Strompfades im Filter verhindert.

Erfindungsgemäß wird der zumindest eine den Ableitstrom führende Strompfad des EMV-Filters unmittelbar nach Detektion einer Asymmetrie deaktiviert, z. B. bei einmaligem Unterschreiten einer Phasenspannung unter einen Referenzwert, so dass ein unsymmetriebedingter Ableitstrom nur über die sehr kurze Ausschaltverzögerungszeit dT_av fließen kann, die kürzer als eine Auslösezeit T_a des Fehlerstromschutzschalters ist. Da die Ausschaltverzögerungszeit dT_av kürzer als die Auslösezeit T_a des Fehlerstromschutzschalters ist, kann dieser innerhalb der Ausschaltverzögerungszeit dT_av nicht auslösen.

Durch ein zeitverzögertes Aktivieren des zumindest einen den Ableitstrom führenden Strompfades des EMV-Filters wird erreicht, dass ein Stromfluss durch das EMV-Filter erst dann ermöglicht wird, wenn alle unsymmetriebedingten Spannungsschwankungen in dem Mehrphasenstromnetz abgeklungen sind.

Um sicherzustellen, dass der Stromfluss durch das EMV-Filter erst dann eingeschaltet wird, wenn das Mehrphasennetz symmetrisch ist, d. h. keine Asymmetrie mehr aufweist, ist vorgesehen, dass die Einschaltverzögerungszeit dT_ev mittels eines Zeitgliedes auf eine Zeit im Bereich von 600 ms ≤ dT ev ≤ 1000 ms, vorzugsweise dT_ev = 800 ms eingestellt wird.

Zum Erzielen eines frühestmöglichen Detektionszeitpunktes ist vorgesehen, dass die Asymmetrie der Phasenspannungen durch Analyse einer durch Gleichrichtung, insbesondere eine 6-Puls-Gleichrichtung, der Phasenspannungen mittels eines Gleichrichters erzeugten pulsierenden Gleichspannung UDC detektiert wird, wobei ein Momentanwert UDC(t) der pulsierenden Gleichspannung UDC mittels eines Momentanwert-Detektors erfasst wird, wobei ein Spitzenwert U_Peak der pulsierenden Gleichspannung UDC ermittelt wird, und wobei der Momentanwert UDC(t) mit dem Spitzenwert U_Peak mittels eines Komparators verglichen wird, und wobei dann, wenn der Momentanwert UDC(t) einmalig einen vorgegebenen Relativwert U_Rel unterschreitet, ein die Asymmetrie anzeigendes Detektionssignal zur Steuerung der Schalteinrichtung erzeugt wird.

Bei dem erfindungsgemäßen Verfahren wird ausgenutzt, dass eine 6-Puls-Gleichspannung eine Welligkeit von lediglich 20 % bei einer Frequenz von 300 Hz aufweist. Folglich liegt bei Auftreten eines Spannungseinbruchs des Momentanwertes der pulsierenden Gleichspannung von mehr als 20 % unter den über die letzte Millisekunde detektierten Spitzenwert bereits eine Unterbrechung einer Phasenspannung vor. Das erfindungsgemäße Verfahren nutzt diese schnellstmögliche Analyse durch Vergleich des Spitzenwertes U_Peak mit dem Momentanwert UDC(t).

Besonders bevorzugt ist der Relativwert U Rel ein Anteil A des Spitzenwertes U_Peak, mit U_Rel = A x U_Peak, wobei der Faktor A im Bereich von 0,75 ≤ A ≤ 0,8 liegt, vorzugsweise A = 0,75 beträgt. Gemäß der Erfindung wird nur ein einziger Komparator eingesetzt, der im Gegensatz zum Stand der Technik die pulsierende Gleichspannung UDC nicht mit einem festen Referenzwert, sondern mit einem definierten Bruchteil A des Spitzenwertes U_Peak ebendieser pulsierenden Gleichspannung UDC, gemittelt über einige Netzperioden, vergleicht.

Folglich werden für die Zustandsermittlung, d. h. für die Erzeugung des Detektionssignals keine absoluten Spannungen gemessen, sondern nur das Verhältnis der Momentanspannung UDC(t) der pulsierenden Gleichspannung UDC zu dem Spitzenwert U_Peak der pulsierenden Gleichspannung UDC. Somit ist die Detektorfunktion über einen weiten Bereich unabhängig vom Absolutwert der Netzspannung. Folglich können mit der gleichen Schaltungsanordnung Stromnetze mit Nennspannungen U_N im Bereich von 200 V ≤ U_N ≤ 500 V überwacht werden. Auch die Netzfrequenz hat im Bereich üblicher Netzfrequenzen keinen Einfluss auf die Funktion der Schaltungsanordnung.

Vorzugsweise wird das Detektionssignal bei Ausfall einer Phasenspannung oder periodisch bei Auftreten einer Unterspannung einer Phasenspannung von z. B. 20 % gegenüber einer Sollspannung erzeugt.

Je nachdem, ob ein stromführender Phasenleiter oder ein nicht stromführender Phasenleiter unterbrochen wird, kann das Detektionssignal DS sofort oder erst innerhalb einer Detektionsverzögerungszeit dT_dv nach dem Eintritt der Asymmetrie erzeugt werden. Die Detektionsverzögerungszeit dT_dv kann im Bereich 0 ms ≤ dT_dv ≤ dT_dvmax liegen, wobei die maximale Detektionsverzögerungszeit dT_dvmax durch den Faktor A bestimmt ist und bei einem Faktor A im Bereich von 0,75 ≤ A ≤ 0,8 im Bereich 3 ms ≤ dT_dvmax ≤ 4 ms liegt.

Über den Faktor A kann die Empfindlichkeit, d. h. die Detektionsverzögerungszeit dT_dv des Asymmetriedetektors optimiert werden. Im optimalen Fall fällt die Momentanspannung UDC(t) unmittelbar nach Ausfall einer Phasenspannung unter den Relativwert U_Rel = A x U_Peak ab, so dass die Detektionsverzögerungszeit dT_dv = 0 ms beträgt. In diesem Fall wird das Detektionssignal im Wesentlichen verzögerungsfrei generiert. Im ungünstigsten Fall fällt die Phasenspannung zu einem Zeitpunkt ab, zu dem die Summe der verbleibenden Phasenspannungen so groß ist, dass der Momentanwert UDC(t) verzögert, d. h. erst nach Ablauf der Detektionsverzögerungszeit dT_dv, unter den Relativwert U_Rel fällt. Je nach Zeitpunkt des Abschaltens einer Phasenspannung liegt die Detektionsverzögerungszeit dT_dv im Bereich zwischen 0 ms ≤ dT_dv ≤ 4 ms. Die maximale Detektionszeit kann über den Faktor A eingestellt werden. Bei A = 0,75 ergibt sich eine maximale Detektionszeit dT dv von 4 ms, die nicht überschritten werden sollte. Ein Faktor A kleiner als 0,75 würde zu längeren Detektionszeiten führen, was unerwünscht ist. Ein Faktor A größer als 0,8 würde zu sehr kurzen Detektionszeiten führen, wodurch die Störanfälligkeit der Schaltung erhöht würde.

Vorzugsweise wird als Schalteinrichtung ein Schaltrelais mit einer Reaktionszeit T_r von maximal T_r = 2,5 ms verwendet, so dass sich die Ausschaltverzögerungszeit dT av aus einer Summe der Detektionsverzögerungszeit dT_dv des Asymmetriedetektors, einer Verzögerungszeit dT_off des Zeitgliedes und der Reaktionszeit T_r des Schaltrelais ergibt und vorzugsweise im Bereich 0 ms ≤ dT_av ≤ dT_avmax liegt, wobei vorzugsweise dT_avmax = dT_dvmax + dT_off + T_r = 4 ms + 0,5 ms + 2,5 ms = 7 ms beträgt. Da ein Fehlerstromschutzschalter des Typs A üblicherweise eine Auslösezeit im Bereich von T_a ≥ 8 ms aufweist, kann dieser während der Ausschaltverzögerungszeit dT_avmax von 7 ms nicht auslösen.

Das erfindungsgemäße Verfahren zeichnet sich insbesondere dadurch aus, dass trotz vorgeschaltetem Fehlerstromschutzschalter beliebig hohe Kapazitäten zu- und abgeschaltet werden können. Folglich können EMV-Filter mit höheren Kapazitäten und kleineren Induktivitäten bzw. ohne Induktivitäten realisiert werden. Die EMV-Filter können kostengünstiger hergestellt werden, da Kondensatoren günstiger als aufwendig gewickelte Drosseln sind.

Zur Bestimmung des Spitzenwertes U_Peak wird vorzugsweise ein Kondensator über eine Diode mit der pulsierenden Gleichspannung UDC aufgeladen, wobei der Relativwert U_Rel mittels eines Spannungsteilers aus dem an dem Kondensator anliegenden Spitzenwert U_Peak abgeleitet wird, und wobei der Spannungsteiler ein einstellbares Teilerverhältnis Tv aufweist mit dem der Relativwert U Rel auf den Anteil A des Spitzenwertes U_Peak eingestellt wird.

Vorzugsweise wird das Detektionssignal bei Unterschreiten des Momentanwertes UDC(t) unter den Relativwert U_Rel im Wesentlichen verzögerungsfrei von dem ersten Zustand, wie HIGH-Signal, in den zweiten Zustand, wie LOW-Signal, gesteuert, wodurch die Schalteinrichtung im Wesentlichen verzögerungsfrei deaktiviert und der Ableitstrom durch das EMV-Filter unterbrochen wird. Ferner wird das Detektionssignal dann, wenn die Phasenspannungen mindestens über die Einschaltverzögerungszeit dT_ev unterbrechungsfrei im Wesentlichen die gleiche Spannung aufweisen, von dem zweiten Zustand, wie LOW-Signal, in den ersten Zustand, wie HIGH-Signal, geschaltet, wodurch die Schalteinrichtung aktiviert und das EMV-Filter vollumfänglich funktionstüchtig geschaltet wird.

Das EMV-Filter kann vorzugsweise eine Sternschaltung aus drei X-Kondensatoren umfassen, wobei jeder der X-Kondensatoren in einem Strompfad liegt, der mit einem ersten Anschluss mit einem der Phasenleiter und mit einem zweiten Anschluss mit einem gemeinsamen Sternpunkt verbunden ist und wobei das EMV-Filter einen Y-Kondensator umfasst, der in einem Strompfad liegt, dessen erster Anschluss mit einem Schutzleiter des Mehrphasenstromnetzes und dessen zweiter Anschluss mit dem Sternpunkt verbunden ist, wobei die die X-Kondensatoren aufweisenden Strompfade oder der den Y-Kondensator aufweisende Strompfad mittels der Schalteinrichtung, vorzugsweise in Form eines Schaltkontaktes eines Steuerrelais, aktiviert oder deaktiviert wird
Alternativ kann das EMV-Filter ein Erdungskondensator eines Umrichters sein, der in dem den Ableitstrom führenden Strompfad liegt und mit einem ersten Anschluss mit dem Schutzleiter des Mehrphasenstromnetzes verbunden ist und dessen zweiter Anschluss mittels der Schalteinrichtung in Form eines Schaltkontaktes eines Steuerrelais zur Aktivierung/Deaktivierung des Stromflusses mit einem Pol eines Zwischenkreises des Umrichters verschaltet, wie verbunden oder getrennt, wird.

Um sicherzustellen, dass der Asymmetriedetektor nur bei reiner Wechselspannung arbeitet, ist vorgesehen, dass mittels eines Wechselspannungsdetektors eine reine Wechselspannung des Mehrphasenstromnetzes detektiert wird, wobei bei Anliegen einer reinen Wechselspannung ein erstes Signal erzeugt wird, mittels dem der Asymmetriedetektor aktiviert und wobei bei Wegfall der reinen Wechselspannung ein zweites Signal erzeugt wird, mittels dem der Asymmetriedetektor deaktiviert wird.

Damit der Komparator auch bei Wegfall einer Phasenspannung, d. h. z. B. im Zweileiterbetrieb weiter aktiv ist, wird dieser über eine Zeitspanne dT_p, mit dT_p im Bereich von zumindest 50 ms bis 500 ms, mittels einer gepufferten Spannungsversorgung mit Spannung versorgt.

Die Aufgabe wird zudem durch eine Schaltungsanordnung zum Betreiben eines EMV-Filters an einem Phasenspannungen aufweisenden Mehrphasenstromnetz mit Merkmalen des Anspruchs 11 gelöst.

Gemäß der Erfindung ist vorgesehen, dass der zumindest eine den Ableitstrom führende Strompfad des EMV-Filters innerhalb einer Ausschaltverzögerungszeit dT_av nach Eintritt der Asymmetrie deaktiviert wird, wobei die Ausschaltverzögerungszeit dT_av kürzer als die Auslösezeit T_a des Fehlerstromschutzschalters ist.

Der Asymmetriedetektor umfasst besonders bevorzugt einen Gleichrichter, der ausgebildet ist, die Phasenspannungen gleichzurichten, einen Spitzenwert-Detektor, der ausgebildet ist, einen Spitzenwert U_Peak der pulsierenden Gleichspannung UDC des Gleichrichters zu erfassen, einen Momentanwert-Detektor, der ausgebildet ist, einen Momentanwert MDC(t) der pulsierenden Gleichspannung UDC des Gleichrichters zu erfassen, einen Komparator, der ausgebildet ist, den Momentanwert UDC(t) mit dem Spitzenwert U_Peak zu vergleichen, wobei ein Ausgang des Komparators mit einem Eingang der Schalteinrichtung gekoppelt ist.

Ein Ausgang des Komparators ist vorzugsweise mit einem Eingang eines Zeitgliedes gekoppelt, dessen Ausgang mit einem Eingang einer Triggerschaltung, wie Schmitt-Trigger, verbunden ist und wobei ein Ausgang der Triggerschaltung vorzugsweise über einen Pegelwandler mit dem Eingang der Steuereinheit verbunden ist.

Das EMV-Filter kann eine Sternschaltung aus drei X-Kondensatoren umfassen, wobei jeder der X-Kondensatoren in einen Strompfad liegt, der mit einem ersten Anschluss mit einem der Phasenleiter und mit einem zweiten Anschluss mit einem gemeinsamen Sternpunkt verbunden ist und wobei das EMV-Filter einen Y-Kondensator umfasst, der in einem Strompfad liegt, dessen erster Anschluss an dem Sternpunkt und dessen zweiter Anschluss an dem Schutzleiter liegt, wobei die Schalteinrichtung in jeweils einem der Strompfade der X-Kondensatoren und/oder in dem Strompfad des Y-Kondensators angeordnet ist.

Alternativ kann das EMV-Filter ein Erdungskondensator eines Umrichters sein, der in dem den Ableitstrom führenden Strompfad liegt und dessen erster Anschluss mit dem Schutzleiter des Mehrphasenstromnetzes verbunden ist und dessen zweiter Anschluss mittels der Schalteinrichtung zur Aktivierung/Deaktivierung des Stromflusses mit einem Pol eines Zwischenkreises des Umrichters verschaltbar ist.

Vorzugsweise umfasst die Schalteinrichtung ein Steuerrelais mit einem Schaltkontakt, wobei der Schaltkontakt in dem Strompfad des Y-Kondensators, in den Strompfaden der X-Kondensatoren und/oder in dem Strompfad des Erdungskondensators angeordnet ist. Die Schalteinrichtung umfasst zudem ein Schaltelement, wie Transistor, zur Ansteuerung des Steuerrelais. Das Steuerrelais hat eine Reaktionszeit T_r von vorzugsweise ca. 2,5 ms.

Der Spitzenwert-Detektor umfasst vorzugsweise eine Diode und einen Kondensator, die parallel zu dem Ausgang des Gleichrichters geschaltet sind, wobei parallel zu dem Kondensator ein Spannungsteiler aus Widerständen geschaltet ist und wobei eine Mittelanzapfung des Spannungsteilers mit dem invertierenden Eingang des Komparators verbunden ist.

Der Momentanwert-Detektor zur Erfassung des Momentanwertes UDC(t) der Ausgangsspannung UDC des Gleichrichters ist vorzugsweise aus einem Spannungsteiler aus den Widerständen ausgebildet, der parallel zu den Ausgängen UDC+, UDC- des Gleichrichters geschaltet ist, wobei eine Mittelanzapfung des Spannungsteilers aus den Widerständen mit einem nicht invertierenden Eingang des Komparators verbunden ist.

Ferner umfasst die Schaltungsanordnung vorzugsweise einen Wechselspannungsdetektor, der ausgebildet ist, eine reine Wechselspannung des Mehrphasenstromnetzes zu detektieren, wobei bei Anliegen einer reinen Wechselspannung ein erstes Signal erzeugt wird, mittels dem der Asymmetriedetektor aktiviert und wobei bei Wegfall der reinen Wechselspannung ein zweites Signal erzeugt wird, mittels dem der Asymmetriedetektor deaktiviert wird.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von den Zeichnungen zu entnehmenden bevorzugten Ausführungsbeispielen.

Es zeigen:
- Fig. 1: ein Prinzipschaltbild der Schaltungsanordnung,
- Fig. 2: ein Prinzipschaltbild einer Detektorschaltung,
- Fig. 3: ein Prinzipschaltbild eines Umrichters mit einem schaltbaren EMV-Filter,
- Fig. 4: ein Diagramm mit Spannungs-Zeit-Verläufen einer stromführenden Phase ohne Abschaltverzögerung, und
- Fig. 5: ein Diagramm mit Spannungs-Zeit-Verläufen einer nicht stromführenden Phase mit Abschaltverzögerung.

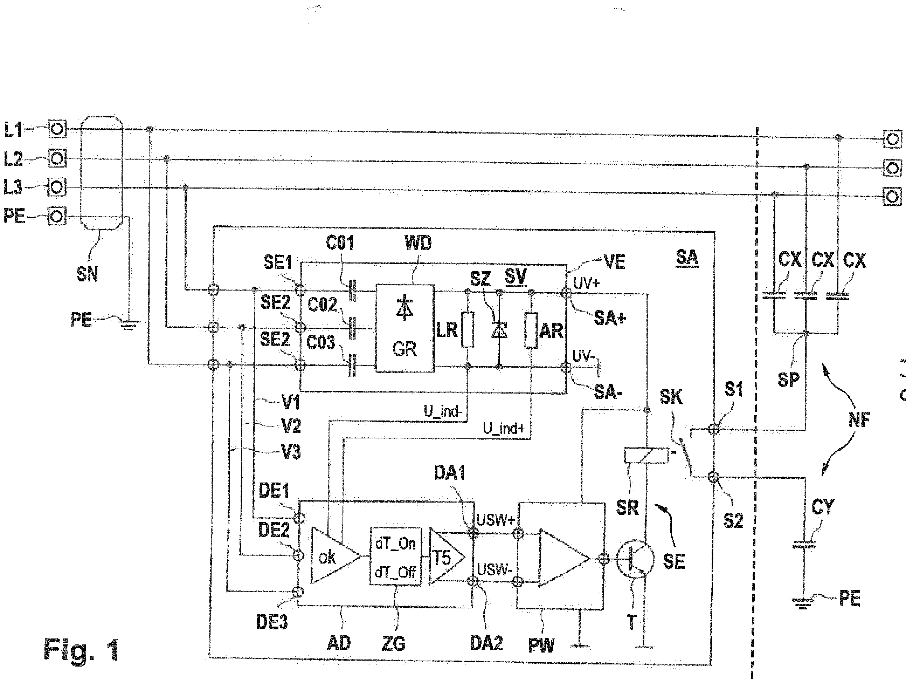

Fig. 1 zeigt rein schematisch eine Schaltungsanordnung SA zum Betrieb eines EMV-Filters NF an einem Dreiphasenstromnetz SN mit Phasenleitern L1, L2, L3 und einem Schutzleiter PE. Das EMV-Filter NF weist drei Stempunktkondensatoren CX auf, die mit einem Anschluss jeweils mit einem der Phasenleiter L1, L2, L3 des Dreiphasenstromnetzes SN verbunden und mit einem zweiten Anschluss an einen gemeinsamen Sternpunkt SP verschaltet sind. Ferner umfasst das EMV-Filter NF einen Erdungskondensator CY, der mit einem ersten Anschluss mit dem Schutzleiter PE und mit einem zweiten Anschluss über eine Schalteinrichtung SE mit dem Sternpunkt SP verbindbar ist. Die Schalteinrichtung SE umfasst ein Steuerrelais SR mit einem Schaltkontakt SK, der in dem Strompfad des Erdungskondensators CY liegt und mit dem der zweite Anschluss des Erdungskondensators CY mit dem Sternpunkt SP verbindbar ist. Das Steuerrelais SR ist mittels eines Transistors T aktivierbar bzw. deaktivierbar.

Die Schaltungsanordnung SA umfasst einen Asymmetriedetektor AD mit Eingängen DE1, DE2, DE3, die mit den Phasenleitern L1, L2, L3 verbunden sind und mit einem Ausgang DA1, DA2, an dem ein Detektionssignal, wie Steuerspannung USW+, USW-, zur Aktivierung oder Deaktivierung des Steuerrelais SR anliegt, wobei das Detektionssignal gegebenenfalls über einen Pegelwandler PW mit einem Steuereingang ES der Steuereinheit SE gekoppelt ist.

Der Asymmetriedetektor AD ist ausgebildet, um die Augenblickswerte der Phasenspannungen UL1, UL2, UL3 zu detektieren und bei einem Ausfall oder einem Spannungseinbruch einer oder mehrerer Phasenspannungen UL1, UL2, UL3 um z. B. zumindest 25 % ihres Sollwertes innerhalb einer Ausschaltverzögerungszeit dT_av, die im Bereich von 0 ms ≤ dT_av ≤ 7 ms liegen kann, das Detektionssignal zur Detektion der Asymmetrie zu erzeugen und mittels des Detektionssignals durch nahezu verzögerungsfreies Ansteuern der Schalteinheit SE den den Ableitstrom führenden Strompfad des EMV-Filters zu deaktivieren, so dass durch den Ausfall oder Spannungseinbruch verursachte Ableitströme nicht mehr zum Schutzleiter PE abfließen können. Folglich fließt der Ableitstrom maximal während der Ausschaltverzögerungszeit dT_av, die so kurz eingestellt ist, dass diese kürzer als eine Auslösezeit T_a eines vorgeschalteten Fehlerstromschutzschalters ist, so dass dieser durch den durch das EMV-Filter verursachten unsymmetriebedingten Ableitstrom nicht auslösen kann.

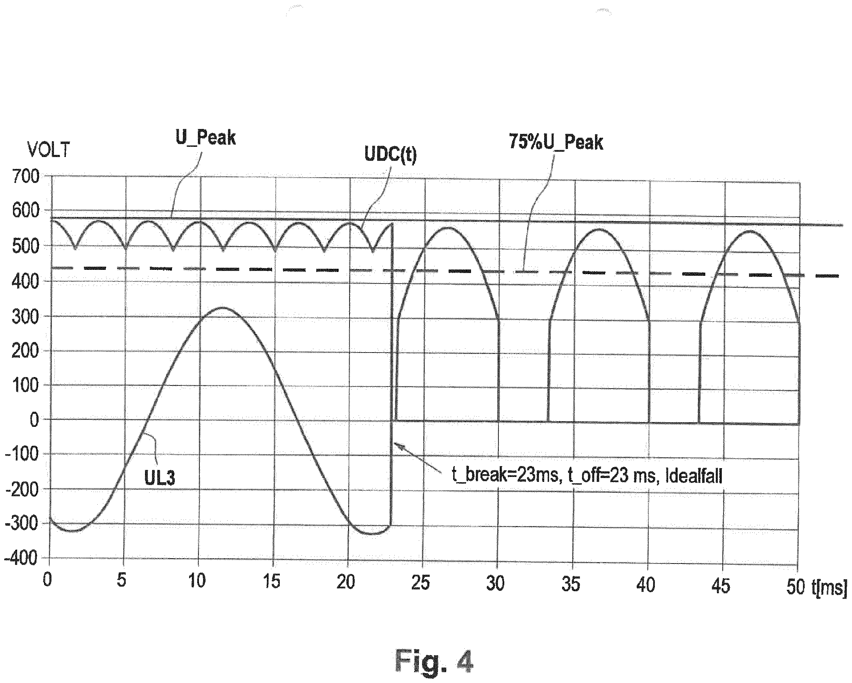

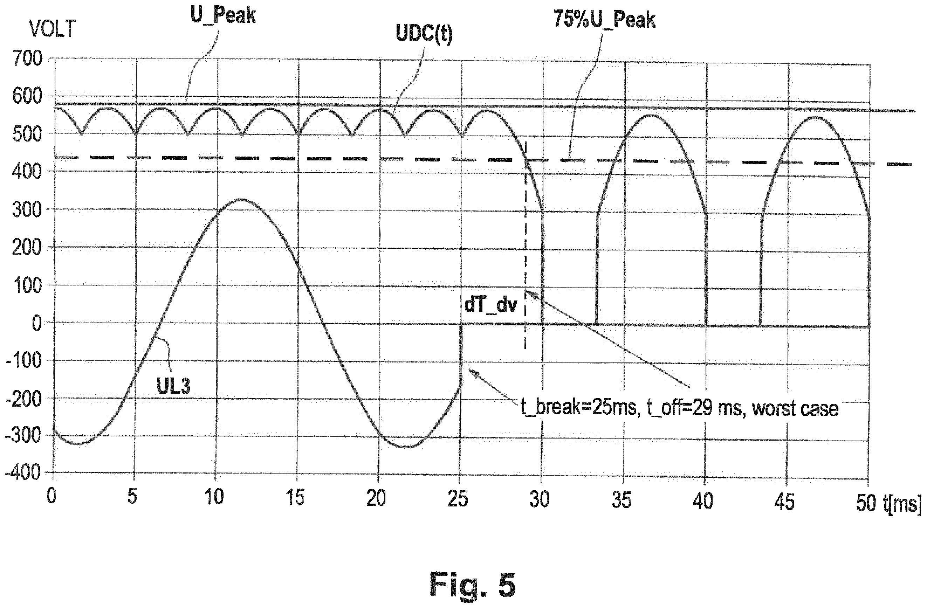

Die Augenblickswerte der Phasenspannungen werden gemäß der Erfindung nicht gemessen. Detektion der Augenblickswerte der Phasenspannungen im Sinne der Erfindung bedeutet nicht die Messung der Augenblickswerte z. B. gegen einen Sternpunkt. Gemäß der Erfindung werden die Augenblickswerte mittels des Gleichrichters detektiert, um aus den Phasenspannungen eine pulsierende Gleichspannung zu erzeugen. Dabei wird ausgenutzt, dass in dem Verlauf der pulsierenden Gleichspannung UDC Informationen über den Verlauf der Augenblickswerte der Phasenspannungen enthalten sind. Folglich können aus dem Verlauf der pulsierenden Gleichspannung Detektionssignale zur Detektion einer Symmetrie oder Asymmetrie der Phasenspannungen abgeleitet werden, wie im Zusammenhang mit Fig. 4 und 5 näher erläutert wird.

Ferner ist der Asymmetriedetektor AD derart ausgebildet, um das Steuerrelais SR einzuschalten, wenn die drei Phasenspannungen UL1, UL2, UL3 in etwa gleicher Höhe - unterbrechungsfrei über eine Einschaltverzögerungszeit dT_ev anliegen. Die Einschaltverzögerungszeit dT_ev liegt im Bereich 600 ms ≤ dT_ev ≤ 1000 ms und ist vorzugsweise auf T_ev = 800 ms eingestellt, so dass der den Ableitstrom führende Strompfad des EMV-Filters erst dann zugeschaltet wird, wenn das Dreiphasenstromnetz SN sicher eingeschwungen ist und das EMV-Filter normal arbeiten kann.

Die Schaltungsanordnung SA umfasst zudem eine Versorgungseinheit VE mit einer Stromversorgung SV und einem Wechselspannungsdetektor WD.

Die Stromversorgung SV ist ausgebildet, um eine Versorgungsspannung UV+, UV- für das Steuerrelais SR und den Pegelwandler PW bereitzustellen.

Der Wechselspannungsdetektor WD ist ausgebildet, um ein Steuersignal, wie Steuerspannung U_ind-, U_ind+, zum Aktivieren oder Deaktivieren des Asymmetriedetektors AD zu generieren. Das Steuersignal zeigt an, ob das Dreiphasenstromnetz SN eine reine Wechselspannung bereitstellt. Die Detektion einer reinen Wechselspannung ist für den Betrieb des EMV-Filters NF notwendig, da nach dem Abschalten der Phasenspannungen UL1, Ul2, UL3 diejenigen Kondensatoren CX, CY des EMV-Filters, die zuletzt an Spannung lagen, aufgrund ihrer in der Regel hohen Kapazitäten und der Größe der meist verwendeten Entladewiderstände nicht vorhersagbare Momentanspannungen bis zu mehreren Sekunden speichern können. Da der Asymmetriedetektor AD auf der Basis der Wechselspannungsverläufe der Phasenspannungen UL1, UL2, UL3 arbeitet, könnten die an den Kondensatoren CX, CY anliegenden Momentanspannungen zu fehlerhaftem Verhalten führen. Folglich wird der Asymmetriedetektor AD nur dann aktiviert, wenn das Dreiphasenstromnetz eine reine Wechselspannung bereitstellt.

Die Versorgungseinheit VE ist eingangsseitig über Eingänge SE1, SE2, SE3 mit den Phasenleitern L1, L2, L3 verbunden. Ausgangsseitig weist die Versorgungseinheit VE einen Spannungsausgang SA+, SA- auf, an dem eine Versorgungsspannung UV+, UVanliegt, mittels der das Steuerrelais SR und der Pegelwandler PW versorgt werden.

Die Stromversorgung SV umfasst einen Gleichrichter GR, vorzugsweise in Form eines B6-Brückengleichrichters, dessen Eingänge jeweils über einen Kondensator C01, C02, C03 mit einem Phasenleiter L1, L2, L3 verbunden sind. Ein Ausgang des Gleichrichters GR ist mit dem Spannungsausgang SA+, SA- verbunden.

Parallel zu dem Ausgang des Gleichrichters GR ist ein Lastwiderstand LR und eine Stabilisierungsdiode SZ geschaltet, die auch den Spannungsausgang SA+, SA- bilden.

Das Steuersignal U_ind-, U_ind+ wird über einen Ausgangswiderstand AR ausgekoppelt, der mit einem ersten Anschluss mit dem Spannungsausgang SA+ verbunden ist. Ein zweiter Anschluss des Ausgangswiderstandes AR bildet zusammen mit Massepotential einen Ausgang für das Steuersignal U_ind+, U_ind-, mit dem das Anliegen der reinen Wechselspannung angezeigt wird.

Die Kondensatoren C01, C02, C03 wirken als hohe kapazitive Vorwiderstände und ermöglichen über den Brückengleichrichter GR und den Lastwiderstand LR eine unkomplizierte Reduktion einer ggf. an den Kondensatoren CX, CY anliegenden ca. 600 V hohen Gleichspannung auf einen für das Steuerrelais SR geeigneten Spannungswert, ohne Erzeugung von Wärme in ohmschen Widerständen.

Die Stabilisierungsdiode SZ begrenzt die Spannung über dem Lastwiderstand LR auf die Versorgungsspannung UV+, UV- des Steuerrelais SR, wodurch der Betrieb der Schaltung an Spannungsnetzen von 200 V bis 500 V ermöglicht wird.

Weiterhin bildet der Lastwiderstand LR mit den Kondensatoren C01, C02, C03 ein Differenzierglied mit einer Zeitkonstanten im Bereich von 5 ms. Bei Wegfall von zwei oder aller drei Phasenspannungen UL1, UL2, UL3, genauer bei Wegfall der dU/dt-Komponente, bricht die Spannung an dem Lastwiderstand RL zusammen. Eine auf den Phasenleitern L1, L2, L3 verbleibende Gleichspannung kann somit nicht an den Lastwiderstand LR gelangen.

Über den Ausgangswiderstand AR wird das Steuersignal U_ind+/U_ind- ausgekoppelt, mittels dem ein Steuerelement, wie Optokoppler OK, zur Aktivierung bzw. Deaktivierung des Asymmetriedetektors AD angesteuert wird. Bei Anliegen einer Wechselspannung an dem Gleichrichter GR wird der Optokoppler OK durchgesteuert und der Asymmetriedetektor AD wird in einen wirksamen Zustand geschaltet.

Bei Wegfall des Steuersignals U_ind+, U_ind-, d. h. bei Anliegen einer hohen Gleichspannung an dem Gleichrichter GR, wird der Asymmetriedetektor AD in einen unwirksamen Zustand geschaltet. Somit ist eine Fehldetektion infolge der Restspannungen an den Kondensatoren CX ausgeschlossen.

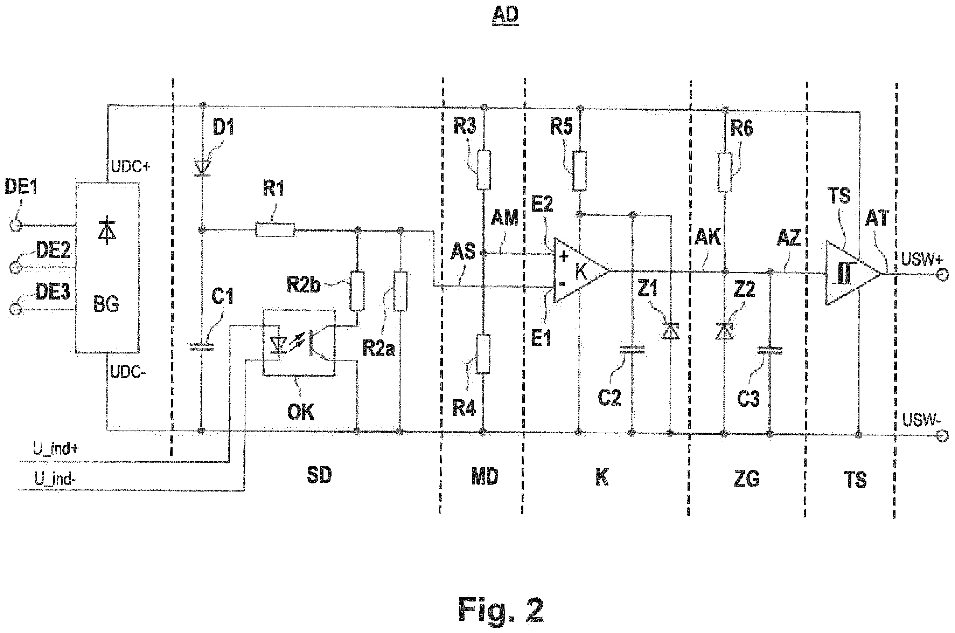

Fig. 2 zeigt ein Prinzipschaltbild des eigenerfinderischen Asymmetriedetektors AD. Dieser umfasst einen Gleichrichter BG in Form eines B6-Brückengleichrichters, der eingangsseitig mit den Anschlüssen DE1, DE2, DE3 die über Verbindungsleitungen V1, V2, V3 mit jeweils einem Phasenleiter L1, L2, L3 des Dreiphasenstromnetzes SN verbunden ist.

Die an den Ausgängen UDC+ und UDC- des Gleichrichters BG anliegende pulsierende Gleichspannung UDC wird mittels eines Spitzenwert-Detektors SD und eines Momentanwert-Detektors MD erfasst. Ein Ausgang AS des Spitzenwert-Detektors SD ist mit einem invertierenden Eingang E1 eines Komparators K und ein Ausgang AM des Momentanwert-Detektors MD ist mit einem nichtinvertierenden Eingang E2 des Komparators K verbunden.

Der Spitzenwert-Detektor SD ist zur Erfassung eines Spitzenwertes U_Peak der pulsierenden Gleichspannung UDC des Gleichrichters BG ausgebildet und umfasst eine Diode D1, deren Anode mit dem Ausgang UDC+ verbunden ist und deren Kathode über einen Kondensator C1 mit dem Ausgang UDC- verbunden ist. Der Kondensator C1 wird über die Diode D1 auf den Spitzenwert U_Peak der pulsierenden Gleichspannung UDC aufgeladen.

Ein zwischen der Kathode der Diode D1 und dem Kondensator C1 liegender Anschluss ist über einen Spannungsteiler mit den Widerständen R1 und R2a an den Ausgang UDCgeschaltet. Eine Mittelanzapfung des Spannungsteilers aus den Widerständen R1, R2a bildet den Ausgang AS, der mit dem invertierenden Eingang E1 des Komparators K verbunden ist. Die Widerstände R1, R2a sind üblicherweise so ausgelegt, dass eine Vergleichsmessung an dem Komparator optimal wirksam ist.

Optional kann ein Spannungsteilerzweig mit einem zusätzlichen Widerstand R2b vorgesehen sein, der mittels eines Schaltelementes OK, wie Optokoppler, parallel zu dem Widerstand R2a schaltbar ist. Die Spitzenwertspannung U_Peak kann in diesem Fall entweder über den Spannungsteiler R1, R2a oder über den Spannungsteiler R1, R2a, R2b in geeigneter Weise geteilt und über den Ausgang AS dem invertierenden Eingang E1 des Komparators K zugeführt werden. Der Optokoppler OK weist einen Steuereingang auf, an dem das Steuersignal U_in+, U_ind- des Wechselspannungsdetektors WD anliegt. Bei Anliegen einer Wechselspannung an dem Gleichrichter GR wird der Optokoppler OK durchgesteuert und der Spannungsteiler R1, R2a, R2b ist wirksam. Dieser ist so ausgelegt, dass die Vergleichsmessung an dem Komparator optimal wirksam ist. Bei Wegfall des Steuersignals U_in+, U_in- erfolgt eine Verstimmung des Spannungsteilers, wobei der Spannungsteiler R1, R2a wirksam ist. Dieser liefert eine Spannung, die den Komparator stets auf LOW-Potential hält, so dass eine Fehlfunktion infolge von Restspannungen an den Kondensatoren CX ausgeschlossen ist.

Der Momentanwert-Detektor MD ist zur Erfassung eines Momentanwertes UDC(t) der pulsierenden Gleichspannung UDC des Gleichrichters BG ausgebildet und umfasst einen Spannungsteiler aus einer Reihenschaltung von Widerständen R3 und R4, die parallel zu der Ausgangsspannung an den Ausgängen UDC+, UDC- liegen. Eine Mittelanzapfung des Spannungsteilers der Widerstände R3, R4 bildet den Ausgang AM und ist mit dem nicht invertierenden Eingang E2 des Komparators K verbunden.

Der Komparator K ist zum Vergleich der an den Eingängen E1, E2 anliegenden Spannungen ausgebildet und wird über eine Pufferschaltung, umfassend den Widerstand R5, den Kondensator C2 und die Diode Z1, mit einer gepufferten Spannung versorgt. Somit kann ein Wegfall der Gleichspannung UDC bis zu mehreren 100 ms überbrückt werden und die Auswertung der Spannungen an dem Komparator K kann fehlerfrei erfolgen. Dies ist zur sicheren Detektion z. B. eines Zweiphasenbetriebs erforderlich.

Ein Ausgang AK des Komparators K ist mit einem Zeitglied ZG verbunden, umfassend einen Widerstand R6, der mit dem Ausgang UDC+ des Gleichrichters BG verbunden ist und einen Kondensator C3, der mit dem Ausgang UDC- des Gleichrichters BG verbunden ist. Parallel zu dem Kondensator C3 ist eine Z-Diode Z2 geschaltet.

Ein Ausgang AZ des Zeitgliedes ZG ist mit einem Eingang ET einer Triggerschaltung TS, wie Schmitt-Trigger, verbunden, dessen Ausgang AT über einen Pegelwandler PW mit einem Steuereingang B, wie Basis, des Schaltelementes T, wie Schalttransistors, verbunden ist. Über den Schalttransistor T ist ein erster Anschluss des Schaltrelais SR mit dem Ausgang SA- der Stromversorgung SV verbindbar. Ein zweiter Anschluss des Schaltrelais SR ist mit einem Ausgang SA+ der Stromversorgung SV verbunden.

Die Funktion der Schaltungsanordnung SA ist wie folgt. Die Augenblickswerte der Phasenspannungen UL1, UL2, UL3 werden detektiert und in Abhängigkeit der Augenblickswerte der Phasenspannungen UL1, UL2, UL3 wird der Kontakt SK des Steuerrelais SR im Strompfad des Kondensators CY geschlossen oder geöffnet, um einen Ableitstrom durch den Kondensator CY zu ermöglichen oder zu verhindern.

Wird das Anliegen aller drei Phasenspannungen UL1, UL2, UL3 in etwa gleicher Höhe unterbrechungsfrei über eine Einschaltverzögerungszeit dT_ev von mindestens z. B. 800 ms erkannt, wird das Steuerrelais SR aktiviert, so dass der Kondensator CY mit dem Sternpunkt SP verbunden und folglich das EMV-Filter NF vollumfänglich funktionstüchtig ist.

Sobald auch nur eine der drei Phasenspannungen ausfällt oder ihren Sollwert um zumindest 25 % unterschreitet, wird das Steuerrelais SR nahezu verzögerungsfrei abgeschaltet, wodurch der Strompfad des Kondensators CY geöffnet und der Ableitstrom unterbrochen wird. Dadurch wird erreicht, dass zu einem frühestmöglichen Zeitpunkt, zu dem noch nicht alle drei Phasenspannungen UL1, UL2, UL3 abgeschaltet sind, der Kondensator CY von dem Sternpunkt SP getrennt wird mit der Folge, dass Ableitströme nicht mehr zu dem Schutzleiter PE fließen können und somit eine Fehlauslösung des Fehlerstromschutzschalters auch beim Abschalten verhindert wird; denn durch die schnelle Detektion und die augenblickliche Abschaltung fließen unsymmetriebedingte Ableitströme nur für einen kurzen Zeitabschnitt, der kleiner ist als eine Auslösezeit T_a des Fehlerstromschutzschalters.

Um einen frühestmöglichen Detektionszeitpunkt zu erzielen, werden die Phasenspannungen UL1, UL2, UL3 gleichgerichtet und der zeitliche Verlauf der an den Ausgängen UDC+, UDC- des Gleichrichters BG, insbesondere 6-Puls-Gleichrichters, anliegenden pulsierenden Gleichspannung UDC ausgewertet. Der Erfindung liegt der Gedanke zugrunde, dass die 6-Puls-Gleichspannung UDC eine Welligkeit von lediglich 20 % bei 300 Hz aufweist und dass bei Auftreten eines Spannungseinbruchs des Momentanwertes UDC(t) der pulsierenden Gleichspannung UDC von mehr als 25 % unter den über die letzte Millisekunde detektierten Spitzenwert U_Peak der pulsierenden Gleichspannung UDC bereits eine Unterbrechung eines Phasenleiters vorliegt.

Der erfindungsgemäße Asymmetriedetektor AD nutzt dieses schnellstmögliche Analyseverfahren, indem der Momentanwert UDC(t) der pulsierenden Gleichspannung UDC mit einem aus dem Spitzenwert U_Peak abgeleiteten Relativwert U_Rel verglichen wird. Wobei der Relativwert U_Rel durch Auslegung des Spannungsteilers R1, R2a, R2b bestimmt wird mit A * U_Peak, wobei A im Bereich 0,75 ≤ A ≤ 0,8, vorzugsweise A= 0,75 beträgt.

Der Spannungsteiler R1, R2a, R2b sowie der Spannungsteiler R3, R4 sind derart ausgelegt, dass der Ausgang AK des Komparators K so lange auf HIGH-Signal liegt, bis der Momentanwert UDC(t) der pulsierenden Gleichspannung UDC einen Wert unterschreitet, der 75 % der Spitzenspannung U_Peak entspricht. In diesem Zustand schaltet der Ausgang AK auf LOW-Signal. Dieser Zustand tritt bei Wegfall einer Phasenspannung UL1, UL2, UL3 oder auch periodisch bei Auftreten einer Unterspannung von etwa 20 % auf einer der Phasenleitungen auf.

Da für die Zustandsermittlung keine absoluten Spannungen gemessen werden, sondern nur das Verhältnis aus Momentanspannung bzw. Momentanwert UDC(t) zur Spitzenspannung bzw. Spitzenwert U_Peak in die Berechnung eingeht, ist die Detektorfunktion über einen weiten Bereich unabhängig vom Absolutwert der Phasenspannung. Es können mit der gleichen Schaltung Netze von 200 V - 500 V überwacht werden. Auch die Netzfrequenz hat im Bereich gebräuchlicher Netzfrequenzen keinen Einfluss auf die Funktion der Schaltung.

Am Ausgang AK des Komparators K mit vorzugsweise OpenCollector-Konfiguration bewirkt das Zeitglied ZG bei HIGH-Signal eine langsame Ladung des Kondensators C3 über den Widerstand R6 über die Einschaltverzögerungszeit dT_ev, die im Bereich 600 ms ≤ dT_ev ≤ 1000 ms liegen kann, vorzugsweise dT_ev = 800 ms beträgt. Die Einschaltverzögerungszeit dT_ev entspricht der Zeitverzögerung dT_On des Zeitgliedes ZG.

Bei LOW-Signal am Ausgang AK des Komparators K erfolgt während einer Zeitverzögerung dT_Off des Zeitgliedes ZG, die im Bereich 0,3 ≤ dT_Off ≤ 0,8 liegt, vorzugsweise dT_Off = 0,5 ms beträgt, eine nahezu schlagartige Entladung des Kondensators C3 über den Ausgangstransistor des Komparators K. Durch die Zeitverzögerung dT_Off können Auslösungen aufgrund von transienten Spannungsspitzen der Netzspannung unterdrückt werden.

Der an sich bekannte Schmitt-Trigger ST schaltet bei einer geeigneten Spannung an dem Kondensator C3 in den HIGH-Zustand und erzeugt so ein universell verwendbares Steuersignal USW+/USW-, das zur Aktivierung/Deaktivierung des Steuerrelais SR aber auch allgemein als Meldesignal für die Symmetrie bzw. Asymmetrie der Phasennetzspannungen einsetzbar ist.

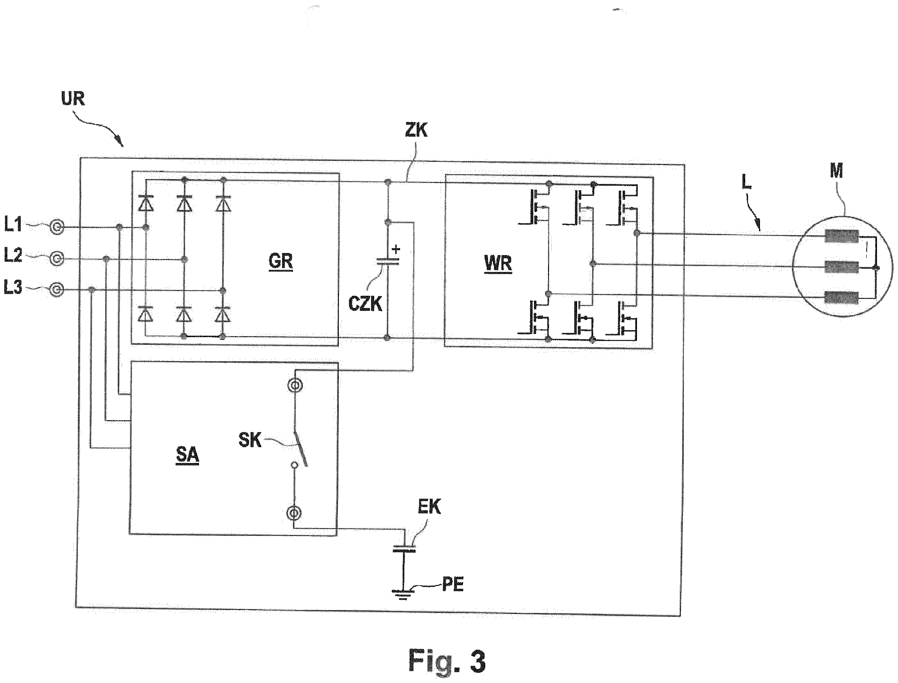

Fig. 3 zeigt einen Umrichter UR mit einem Gleichrichter GR, der eingansseitig mit den Phasenleitern L1, L2, L3 des Mehrphasenstromnetz SN und ausgangsseitig über einen Gleichspannungszwischenkreis ZK mit einem Wechselrichter WR verbunden ist. Der Gleichspannungszwischenkreis ZK umfasst einen Glättungskondensator CZK, der parallel zu einem Ausgang des Gleichrichters GR liegt. An einem Ausgang des Wechselrichters WR ist über eine Leitung L ein Antrieb M angeschlossen.

Zur Entstörung des Wechselrichters WR ist ein EMV-Filter in Form eines Kondensators EK vorgesehen, der in einem Strompfad angeordnet ist, der mit einem ersten Anschluss mit einem Pol des Gleichspannungszwischenkreises ZK und mit einem zweiten Anschluss mit dem Schutzleiter PE verbunden ist. Gemäß der Erfindung ist in dem Strompfad des Kondensators EK ein Schaltkontakt SK angeordnet, der in Abhängigkeit der Symmetrie oder Asymmetrie der Phasenspannungen UL1, UL2, UL3 geschaltet wird. Wird das Anliegen aller drei Phasenspannungen in etwa gleicher Höhe - unterbrechungsfrei über mindestens z. B. 800 ms erkannt, wird der Schaltkontakt aktiviert und das EMV-Filter arbeitet normal. Sobald auch nur eine der drei Phasenspannungen ihren Sollwert mindestens um z. B. 25 % unterschreitet, wird der Schaltkontakt SK nahezu verzögerungsfrei abgeschaltet.

Der Schaltkontakt SK ist Teil der Schaltungsanordnung SA gemäß Fig. 1 und Fig. 2. Die Schaltungsanordnung kann in dem Umrichter UR integriert sein.

Gemäß der Erfindung werden die Augenblickswerte der Phasenspannungen nicht gemessen. Jedoch werden die Augenblickswerte mittels des 6-Wege-Gleichrichters detektiert und gleichgerichtet. Die 6-Wege-Gleichrichtung liefert in Bezug auf den Sternpunkt folgende Spannungen:
1. Die positive Spannung UDC+(t) = MAX[U1(t); U2(t); U3(t)]
2. Die negative Spannung UDC-(t) = MIN [U1(t); U2(t); U3(t)]

Fig. 4 zeigt den zeitlichen Verlauf einer stromführenden Phasenspannung UL3, den Momentanwert UDC(t) der pulsierenden Gleichspannung UDC des Gleichrichters BG sowie den Spitzenwert U_Peak der pulsierenden Gleichspannung UDC unter idealen Bedingungen. Die 6-Wege-Gleichrichtung einer im Wesentlichen perfekt symmetrischen sinusförmigen 3-Phasen Netzspannung führt immer zu einer gleichgerichteten Spannung UDC+ bezogen auf UDC- mit 15,3 % Welligkeit bei 300 Hz. Bereits eine Absenkung einer der drei Phasenspannungen um 10 % führt zu einer Erhöhung der Welligkeit auf 23,6 %.

Eine Messung der Augenblickswerte der drei Phasenspannungen gegen den Sternpunkt erfolgt nicht. Kennzeichen der Erfindung ist die Detektion der Asymmetrie oder Symmetrie ohne Messung der Augenblickswerte gegen Neutralleiter N, da beim Einsatz der Schaltung ein Neutralleiter meist nicht zur Verfügung steht.

Das Messverfahren beruht vielmehr auf der Erfassung zweier Messgrößen der pulsierenden Gleichspannung UDC, nämlich dem Maximalwert U_Peak, der durch Spitzenwertgleichrichtung ermittelt wird, sowie dem Momentanwert UDC (t) der pulsierenden Gleichspannung UDC. Folglich ist die Grundlage des erfindungsgemäßen Verfahrens die Erzeugung der pulsierenden Gleichspannung UDC und die Analyse des Momentanwertes UDC+ (t) in Bezug auf UDC- (t).

Eine Asymmetrie liegt dann vor, sobald der Momentanwert UDC (t) der pulsierenden Gleichspannung UDC in Bezug auf die negative Ausgangsspannung UDC- (t) den Relativwert U_Rel mit U_Rel = A * U_Peak, mit A im Bereich von 0,75 ≤ 0,867, unterschreitet.

Zum Zeitpunkt t_break = 23 ms wird die Phasenspannung UL3 unterbrochen, wodurch der Momentanwert UDC(t) der pulsierenden Gleichspannung UDC zum selben Zeitpunkt t_off = 23 ms verzögerungsfrei unter den Relativwert U_Rel abfällt. Der Spannungseinbruch der Phasenspannung UL3 und das Unterschreiten des Momentanwertes UDC(t) der pulsierenden Gleichspannung UDC unter den Relativwert U_Rel = 0,75 * U_Peak erfolgt im Idealfall verzögerungsfrei, d. h. mit einer Detektionsverzögerungszeit dT_dv = 0 ms.

Der Relativwert U Rel der Spitzenspannung U_Peak liegt an dem invertierenden Eingang E1 des Komparators K an, während der Momentanwert UDC(t) der pulsierenden Gleichspannung UDC über den Spannungsteiler R3, R4 an dem nicht invertierenden Eingang E2 des Komparators K anliegt. Der Komparator K vergleicht den Relativwert U_Rel mit dem Momentanwert UDC(t). Sobald der Momentanwert UDC(t) den Relativwert U_Rel, der 75 % des Spitzenwertes U_Peak beträgt, unterschreitet, schaltet der Komparator K über den Pegelwandler PW den Transistor T unverzüglich ab, wodurch das Steuerrelais SR ggf. nach einer Reaktionszeit T_r von ca. T_r = 2,5 ms abfällt und der Strompfad des Y-Kondensators CY des EMV-Filters NF geöffnet wird, mit der Folge, dass keine Ableitströme mehr fließen können. Folglich kann ein Ableitstrom nicht länger als dT dv + dT_Off + T_r = 0 ms + 0,5 ms + 2,5 ms = 3 ms fließen. Da die Auslösezeit T_a eines Fehlerstromschutzschalters üblicherweise im Bereich von T_a > 8 ms liegt, löst dieser noch nicht aus.

Fig. 5 zeigt Spannungs-Zeitverläufe einer nicht stromführenden Phasenspannung UL3, des Spitzenwertes U Peak der pulsierenden Gleichspannung sowie die pulsierende Gleichspannung UDC unter "Worst Case" Bedingungen, wobei die Phasenspannung UL3 zu einem Zeitpunkt t_break = 25 ms abgeschaltet wird. Allerdings fällt der Momentanwert UDC(t) nicht unmittelbar ab, da ab dem Zeitpunkt t_break die Summe der verbleibenden Phasenspannungen größer ist als der Relativwert U_Rel = A * U_Peak. Erst zum Zeitpunkt t_off = 29 ms, wenn auch die weiteren Phasenspannungen sinken, wird der Relativwert 0,75 * U_Peak unterschritten. Die Detektion erfolgt somit erst nach einer Detektionsverzögerungszeit dT_dv von 4 ms. Zusammen mit der Verzögerungszeit T_Off des Zeitgliedes ZG von ca. T_Off = 0,5 ms, der Reaktionszeit T_r des Steuerrelais SR von ca. T_r = 2,5 ms kann ein unsymmetriebedingter Ableitstrom jedoch nicht länger als dT_dv + dT_Off + T_r = 4 ms + 0,5 ms + 2,5 ms = 7 ms fließen und den Fehlerstromschutzschalter nicht auslösen.

Die erfindungsgemäße Schaltungsanordnung eliminiert auch durch Schaltelemente bedingte Prellvorgänge und Kurzzeitunterbrechungen, da jede Unterbrechung einer Phase nach einer maximalen Detektionsverzögerungszeit T_dvmax von 4 ms einen Neustart der Einschaltverzögerungszeit von z. B. 800 ms auslöst.

Fig. 1 zeigt, dass die Schaltungsanordnung SA nur die drei Phasenleiter L1, L2, L3 des Dreiphasenstromnetzes SN benutzt, wobei eine Verbindung zum Neutralleiter oder Schutzleiter PE nicht besteht. Die Eigenschaften des EMV-Filters NF bzgl. Entstörwirkung und Hochspannungsfestigkeit gegen den Schutzleiter PE bleiben unberührt. Mit der Schaltungsanordnung SA können EMV-Filter NF und die nachgeschalteten Verbraucher problemlos an einem Fehlerstromschutzschalter betrieben werden. Eine Fehlabschaltung ist nahezu ausgeschlossen.

## Patentansprüche

1. Verfahren zum Betreiben eines EMV-Filters (NF, EK) an einem Phasenspannungen (UL1, UL2, UL3) aufweisenden Mehrphasenstromnetz (SN), insbesondere Dreiphasenstromnetz, oder in einer an dem Mehrphasenstromnetz (SN) angeschlossenen Komponente, wie Umrichter (UR), wobei in zumindest einem Strompfad des EMV-Filters aufgrund einer Asymmetrie der Phasenspannungen (UL1, UL2, UL3), insbesondere durch Ein- oder Ausschalten des Mehrphasenstromnetzes (SN), ein zu einem Schutzleiter (PE) des Mehrphasenstromnetzes (SN) abfließender Ableitstrom verursacht wird, wobei die Asymmetrie der Phasenspannungen (UL1, UL2, UL3) mittels einer Messeinrichtung (AD) überwacht wird, und wobei der zumindest eine den Ableitstrom leitende Strompfad des EMV-Filters (NF, EK) mittels einer Schalteinrichtung (SE) deaktiviert wird, damit der durch die Asymmetrie verursachte Ableitstrom nicht zum Schutzleiter (PE) abfließen kann,
**dadurch gekennzeichnet,**
**dass** als Messeinrichtung ein Asymmetriedetektor (AD) verwendet wird, wobei die Überwachung der Asymmetrie die Detektion eines Eintritts der Asymmetrie umfasst, dass die Deaktivierung des Strompfades zur Vermeidung einer Fehlabschaltung eines dem EMV-Filter (NF, EK) vorgeschalteten und eine Auslösezeit T_a aufweisenden Fehlerstromschutzschalters mittels der Schalteinrichtung (SE) innerhalb einer Ausschaltverzögerungszeit dT_av nach Eintritt der Asymmetrie erfolgt, wobei die Ausschaltverzögerungszeit dT_av kürzer als die Auslösezeit T_a des Fehlerstromschutzschalters ist und
**dass** der Strompfad erst dann aktiviert wird, wenn die Phasenspannungen (UL1, UL2, UL3) mindestens über eine Einschaltverzögerungszeit dT_ev unterbrechungsfrei im Wesentlichen die gleiche Spannung aufweisen.

2. Verfahren nach Anspruch 1,
**dadurch gekennzeichnet,**
**dass** die Einschaltverzögerungszeit dT_ev mittels eines Zeitgliedes (ZG) auf eine Zeit im Bereich von 600 ms ≤ dT_ev ≤ 1000 ms, vorzugsweise dT_ev = 800 ms eingestellt wird und/oder dass die Ausschaltverzögerungszeit dT_av mittels des Zeitgliedes (ZG) auf eine Zeit im Bereich von 0,3 ms ≤ dT_av ≤ 0,7 ms, vorzugsweise dT_av = 0,5 ms eingestellt wird.

3. Verfahren nach Anspruch 1 oder 2,
**dadurch gekennzeichnet,**
**dass** die Asymmetrie der Phasenspannungen (UL1, UL2, UL3) durch Analyse einer durch Gleichrichtung der Phasenspannungen (UL1, UL2, UL3) mittels eines Gleichrichters (BG) erzeugten pulsierenden Gleichspannung UDC detektiert wird, wobei ein Momentanwert UDC(t) der pulsierenden Gleichspannung UDC mittels eines Momentanwert-Detektors (MD) erfasst wird, wobei ein Spitzenwert U_Peak der pulsierenden Gleichspannung UDC ermittelt wird, und wobei der Momentanwert UDC(t) mit dem Spitzenwert U_Peak mittels eines Komparators (K) verglichen wird, und wobei dann, wenn der Momentanwert UDC(t) einmalig einen vorgegebenen Relativwert U_Rel unterschreitet, ein die Asymmetrie anzeigendes Detektionssignal DS zur Steuerung der Schalteinrichtung (SE) erzeugt wird.

4. Verfahren nach zumindest einem der vorhergehenden Ansprüche,
**dadurch gekennzeichnet,**
**dass** der Relativwert U_Rel ein Anteil A des Spitzenwertes U_Peak ist, mit U_Rel = A x U_Peak, wobei A im Beriech von 0,7 ≤ A ≤ 0,8 liegt, vorzugsweise A = 0,75 beträgt.

5. Verfahren nach zumindest einem der vorhergehenden Ansprüche,
**dadurch gekennzeichnet,**
**dass** das Detektionssignal DS bei Ausfall einer Phasenspannung (UL1, UL2, UL3) oder periodisch bei Auftreten einer Unterspannung einer Phasenspannung (UL1, UL2, UL3) von z. B. 20 % gegenüber einer Sollspannung erzeugt wird und/oder dass das Detektionssignal DS innerhalb einer Detektionsverzögerungszeit dT_dv nach dem Eintritt der Asymmetrie erzeugt wird, wobei die Detektionsverzögerungszeit dT_dv im Bereich 0 ms ≤ dT_dv ≤ dT dvmax liegt, wobei die maximale Detektionsverzögerungszeit dT_dvmax durch den Faktor A bestimmt ist und bei einem Faktor A im Bereich von 0,75 ≤ A ≤ 0,8 im Bereich 3 ms ≤ dT_dvmax ≤ 4 ms liegt und vorzugsweise bei A = 0,75 dT_dvmax = 4 ms beträgt.

6. Verfahren nach zumindest einem der vorhergehenden Ansprüche,
**dadurch gekennzeichnet,**
**dass** als Schalteinrichtung (SE) ein Schaltrelais (SR) mit einer Reaktionszeit T_r im Bereich 0 ms ≤ T_r ≤ 2,5 ms verwendet wird und/oder
**dass** sich die Ausschaltverzögerungszeit dT_av aus einer Summe der Detektionsverzögerungszeit dT_dv des Asymmetriedetektors (AD), einer Verzögerungszeit dT_off des Zeitgliedes (ZG) und der Reaktionszeit T_r des Schaltrelais (SR) ergibt und vorzugsweise im Bereich 0 ms ≤ dT_av ≤ dT_avmax liegt, wobei dT_avmax = dT_dvmax + dT_off + T_r = 4 ms + 0,5 ms + 2,5 ms = 7 ms beträgt.

7. Verfahren nach zumindest einem der vorhergehenden Ansprüche,
**dadurch gekennzeichnet,**
**dass** zur Bestimmung des Spitzenwertes U_Peak ein Kondensator (C1) über eine Diode (D1) mit der pulsierenden Gleichspannung UDC aufgeladen wird, dass der Relativwert U_Rel mittels eines Spannungsteilers (R1, R2a, R2b) aus dem an dem Kondensator (C1) anliegenden Spitzenwert U_Peak abgeleitet wird, wobei der Spannungsteiler (R1, R2a, R2b) vorzugsweise ein einstellbares Teilerverhältnis STV aufweist mit dem der Relativwert U_Rel auf den Anteil A des Spitzenwertes U_Peak eingestellt wird.

8. Verfahren nach zumindest einem der vorhergehenden Ansprüche,
**dadurch gekennzeichnet,**
**dass** das EMV-Filter (NF) eine Sternschaltung aus drei Kondensatoren (CX) umfasst, wobei jeder der Kondensatoren (CX) in einem Strompfad liegt, der mit einem ersten Anschluss mit einem der Phasenleiter (L1, L2, L3) und mit einem zweiten Anschluss mit einem gemeinsamen Sternpunkt (SP) verbunden ist und dass das EMV-Filter (NF) einen Kondensator (CY) umfasst, der in einem Strompfad liegt, dessen erster Anschluss mit einem Schutzleiter (PE) des Mehrphasenstromnetzes (SN) und dessen zweiter Anschluss mit dem Sternpunkt (SP) verbunden ist, wobei die die Kondensatoren (CX) aufweisenden Strompfade oder der den Kondensator (CY) aufweisende Strompfad mittels der Schalteinrichtung (SE) vorzugsweise in Form eines Schaltkontaktes (SK) eines Steuerrelais (SR) aktiviert oder deaktiviert wird.

9. Verfahren nach zumindest einem der vorhergehenden Ansprüche,
**dadurch gekennzeichnet,**
**dass** das EMV-Filter ein Erdungskondensator eines Umrichters ist, der in dem den Ableitstrom leitenden Strompfad liegt und dessen erster Anschluss mit dem Schutzleiter (PE) des Mehrphasenstromnetzes (SN) verbunden ist und dessen zweiter Anschluss mittels der Schalteinrichtung (SE) in Form eines Schaltkontaktes (SK) eines Steuerrelais (SR) zur Aktivierung/Deaktivierung des Stromflusses mit einem Pol eines Zwischenkreises des Umrichters verschaltet, wie verbunden oder getrennt, wird.

10. Verfahren nach zumindest einem der vorhergehenden Ansprüche,
**dadurch gekennzeichnet,**
**dass** mittels eines Wechselspannungsdetektors (WD) eine reine Wechselspannung des Mehrphasenstromnetzes (SN) detektiert wird, wobei bei Anliegen einer reinen Wechselspannung ein erstes Signal erzeugt wird, mittels dem der Asymmetriedetektor (AD) aktiviert wird und wobei bei Wegfall der reinen Wechselspannung ein zweites Signal erzeugt wird, mittels dem der Asymmetriedetektor (AD) deaktiviert wird.

11. Schaltungsanordnung (SA) zum Betreiben eines EMV-Filters (NF) an einem Phasenspannungen (UL1, UL2, UL3) aufweisenden Mehrphasenstromnetz (SN), insbesondere Dreiphasenstromnetz, oder in einer an dem Mehrphasenstromnetz (SN) angeschlossenen Komponente, wie Umrichter, wobei das EMV-Filter (NF) zumindest einen Strompfad aufweist, über den ein aufgrund einer Asymmetrie der Phasenspannungen (UL1, UL2, UL3), insbesondere durch Ein- oder Ausschalten des Mehrphasenstromnetzes (SN), verursachter Ableitstrom zu einem Schutzleiter (PE) des Mehrphasenstromnetzes (SN) abfließt, wobei die Schaltungsanordnung (SA) eine Messeinrichtung (AD) aufweist, die ausgebildet ist, eine Asymmetrie der Phasenspannungen zu überwachen und eine Schalteinrichtung (SE) derart zu steuern, dass der zumindest eine den Ableitstrom leitende Strompfad des EMV-Filters (NF) deaktiviert wird, damit der durch die Asymmetrie verursachte Ableitstrom nicht zu dem Schutzleiter (PE) abfließt,
**dadurch gekennzeichnet,**
**dass** die Messeinrichtung ein Asymmetriedetektor (AD) ist, der ausgebildet ist, einen Eintritt der Asymmetrie zu detektieren, und bei Eintritt der Asymmetrie ein Signal für die Schalteinrichtung (SE) zu erzeugen, so dass die Deaktivierung des zumindest einen den Ableitstrom leitenden Strompfades des EMV-Filters (NF) zur Vermeidung einer Fehlabschaltung eines dem EMV-Filter (NF) vorgeschalteten und eine Auslösezeit T_a aufweisenden Fehlerstromschutzschalters innerhalb einer Ausschaltverzögerungszeit dT av nach Eintritt der Asymmetrie erfolgt, wobei die Zeitspanne dT_av kürzer als die Auslösezeit T_a des Fehlerstromschutzschalters ist und
**dass** eine Aktivierung des Strompfades dann erfolgt, wenn die Phasenspannungen (UL1, UL2, UL3) mindestens über eine definierte Einschaltverzögerungszeit dT_ev unterbrechungsfrei im Wesentlichen die gleiche Spannung aufweisen.

12. Schaltungsanordnung nach Anspruch 11,
**dadurch gekennzeichnet,**
**dass** der Asymmetriedetektor (AD) umfasst:
einen Gleichrichter (BG), der ausgebildet ist, die Phasenspannungen (UL1, UL2, UL3) gleichzurichten, einen Spitzenwert-Detektor (SD), der ausgebildet ist, einen Spitzenwert U_Peak der pulsierenden Gleichspannung UDC des Gleichrichters (BG) zu erfassen, einen Momentanwert-Detektor (MD), der ausgebildet ist, einen Momentanwert MDC(t) der pulsierenden Gleichspannung UDC des Gleichrichters (BG) zu erfassen, einen Komparator (K), der ausgebildet ist, den Momentanwert UDC(t) mit dem Spitzenwert U_Peak zu vergleichen, wobei ein Ausgang (A1) des Komparators (K) mit einem Eingang der Schalteinrichtung (SE) gekoppelt ist.

13. Schaltungsanordnung nach Anspruch 11 oder 12,
**dadurch gekennzeichnet,**
**dass** ein Ausgang (AK) des Komparators (K) mit einem Eingang (ZE) eines Zeitgliedes (ZG) gekoppelt ist, dessen Ausgang (ZA) mit einem Eingang (ET) einer Triggerschaltung (ST) verbunden ist und dass ein Ausgang (TA) der Triggerschaltung (ST) vorzugsweise über einen Pegelwandler (PW) mit dem Eingang (ES) der Steuereinheit (SE) verbunden ist.

14. Schaltungsanordnung nach zumindest einem der Ansprüche 11 bis 13,
**dadurch gekennzeichnet,**
**dass** das EMV-Filter (NF) eine Sternschaltung aus drei Kondensatoren (CX) umfasst, wobei jeder der Kondensatoren (CX) in einem Strompfad liegt, der mit einem ersten Anschluss mit einem der Phasenleiter (L1, L2, L3) und mit einem zweiten Anschluss mit einem gemeinsamen Sternpunkt (SP) verbunden ist und dass das EMV-Filter (NF) einen Kondensator (CY) umfasst, der in einem Strompfad liegt, der mit einen ersten Anschluss an dem Sternpunkt (SP) und mit einem zweiten Anschluss an dem Schutzleiter (PE) liegt, wobei die Schalteinrichtung (SE) in jeweils einem der Strompfade der Kondensatoren (CX) und/oder in dem Strompfad des Kondensators (CY) angeordnet ist.

15. Schaltungsanordnung nach zumindest einem der Ansprüche 11 bis 14,
**dadurch gekennzeichnet,**
**dass** das EMV-Filter ein Erdungskondensator eines Umrichters ist, der in dem den Ableitstrom leitenden Strompfad liegt und mit einem ersten Anschluss mit dem Schutzleiter des Mehrphasenstromnetzes (SN) verbunden ist und dessen zweiter Anschluss mittels der Schalteinrichtung (SE) zur Aktivierung/Deaktivierung des Stromflusses mit einem Pol eines Zwischenkreises des Umrichters verschaltbar ist.

16. Schaltanordnung nach zumindest einem der Ansprüche 11 bis 18,
**dadurch gekennzeichnet,**
**dass** die Schalteinrichtung (SE) ein Steuerrelais (SR) mit einem Schaltkontakt (SK) umfasst, wobei der Schaltkontakt (SK) in dem Strompfad des Kondensators (CY) , den Strompfaden der Kondensatoren (CX) und/oder dem Strompfad des Erdungskondensators angeordnet ist und dass die Schalteinrichtung (SE) vorzugsweise ein Schaltelement (T), wie Transistor, zur Ansteuerung des Steuerrelais (SR) umfasst.

17. Schaltungsanordnung nach zumindest einem der Ansprüche 11 bis 16,
**dadurch gekennzeichnet,**
**dass** die Schaltungsanordnung (SA) einen Wechselspannungsdetektor (WD) umfasst, der ausgebildet ist ein reine Wechselspannung des Mehrphasenstromnetzes zu detektieren, wobei bei Anliegen einer reinen Wechselspannung ein erstes Signal erzeugt wird, mittels dem der Asymmetriedetektor (AD) aktiviert wird und wobei bei Wegfall der reinen Wechselspannung ein zweites Signal erzeugt wird, mittels dem der Asymmetriedetektor (AD) deaktiviert wird.

18. Schaltungsanordnung nach zumindest einem der Ansprüche 11 bis 17,
**dadurch gekennzeichnet,**
**dass** die Schaltungsanordnung (SA) in einem EMV-Filter (NF) oder in einem Umrichter integriert ist.

19. EMV-Filter (NF), umfassend zumindest eine Sternschaltung aus drei Kondensatoren (CX), wobei jeder der Kondensatoren (CX) in einem Strompfad liegt, der mit einem ersten Anschluss mit einem Phasenleiter (L1, L2, L3) eines Mehrphasenstromnetzes (SN) und mit einem zweiten Anschluss mit einem gemeinsamen Sternpunkt (SP) verbunden ist und wobei das EMV-Filter (NF) einen Kondensator (CY) umfasst, der in einem Strompfad liegt, der mit einen ersten Anschluss an dem Sternpunkt (SP) und mit einem zweiten Anschluss an dem Schutzleiter (PE) liegt, wobei die Schalteinrichtung (SE) in jeweils einem der Strompfade der Kondensatoren (CX) und/oder in dem Strompfad des Kondensators (CY) angeordnet und in Abhängigkeit der Symmetrie oder Asymmetrie der Phasenspannungen des Mehrphasenstromnetzes schaltbar ist.

## Claims

1. A method for operating an EMC filter (NF, EK) on a multi-phase network (SN), in particular a three-phase network, having phase voltages (UL1, UL2, UL3), or in a component such as an inverter (UR) connected to the multi-phase network (SN), wherein a leakage current flowing to a protective conductor (PE) of the multi-phase network (SN) is caused in at least one current path of the EMC filter due to an asymmetry of the phase voltages (UL1, UL2, UL3), in particular by switching the multi-phase network (SN) on or off, wherein the asymmetry of the phase voltages (UL1, UL2, UL3) is monitored by means of a measuring device (AD), and wherein the at least one current path of the EMC filter (NF, EK) conducting the leakage current is deactivated by means of a switching device (SE), so that the leakage current caused by the asymmetry cannot flow to the protective conductor (PE),
**characterized in**
**that** an asymmetry detector (AD) is used as the measuring device, wherein monitoring of the asymmetry comprises detection of an occurrence of the asymmetry, that the deactivation of the current path takes place to prevent an unintended shutdown of a residual current circuit breaker connected upstream of the EMC filter (NF, EK) and having a tripping time T_a by means of the switching device (SE) within a switch-off delay time dT_av after occurrence of the asymmetry, wherein the switch-off delay time dT_av is shorter than the tripping time T_a of the residual current circuit breaker, and
**that** the current path is not activated until the phase voltages (UL1, UL2, UL3) have substantially the same voltage without interruption at least over a switch-on delay time dT_ev.

2. The method according to claim 1,
**characterized in**
**that** the switch-on delay time dT_ev is set by means of a timer (ZG) to a time in the range of 600 ms ≤ dT_ev ≤ 1000 ms, preferably dT_ev = 800 ms, and/or that the switch-off delay time dT_av is set by means of the timer (ZG) to a time in the range of 0.3 ms ≤ dT_av ≤ 0.7 ms, preferably dT_av = 0.5 ms.

3. The method according to claim 1 or 2,
**characterized in**
**that** the asymmetry of the phase voltages (UL1, UL2, UL3) is detected by analysis of a pulsating DC voltage UDC generated by rectification of the phase voltages (UL1, UL2, UL3) by means of a rectifier (BG), wherein a momentary value UDC(t) of the pulsating DC voltage UDC is detected by means of a momentary value detector (MD), wherein a peak value U_Peak of the pulsating DC voltage UDC is determined, wherein the momentary value UDC(t) is compared with the peak value U_Peak by means of a comparator (K), and wherein a detection signal DS indicating the asymmetry is generated for controlling the switching device (SE) once the momentary value UDC(t) falls below a predefined relative value U_Rel.

4. The method according to at least one of the preceding claims,
**characterized in**
**that** the relative value U_Rel is a proportion A of the peak value U_Peak, where U_Rel = A x U_Peak, wherein A is the range 0.7 ≤ A ≤ 0.8, preferably A = 0.75.

5. The method according to at least one of the preceding claims,
**characterized in**
**that** the detection signal DS is generated upon failure of a phase voltage (UL1, UL2, UL3) or periodically upon occurrence of an undervoltage in a phase voltage (UL1, UL2, UL3) of for example 20 % relative to a set voltage, and/or that the detection signal DS is generated within a detection delay time dT_dv after the occurrence of the asymmetry, wherein the detection delay time dT_dv is in the range of 0 ms ≤ dT_dv ≤ dT_dvmax, wherein the maximum detection delay time dT_dvmax is determined by the factor A and, in the case of a factor A in the range of 0.75 ≤ A ≤ 0.8, is in the range of 3 ms ≤ dT_dvmax ≤ 4 ms, and preferably A = 0.75 dT_dvmax = 4 ms.

6. The method according to at least one of the preceding claims,
**characterized in**
**that** a switching relay (SR) with a reaction time T_r in the range of 0 ms ≤ T_r ≤ 2.5 ms is used as the switching device (SE) and/or
**that** the switch-off delay time dT av is obtained from a sum of the detection delay time dT_dv of the asymmetry detector (AD), of a delay time dT_off of the timer (ZG) and of the reaction time T_r of the switching relay (SR), and is preferably in the range of 0 ms ≤ dT_av ≤ dT avmax, wherein dT_avmax = dT_dvmax + dT_off + T_r = 4 ms + 0.5 ms + 2.5 ms = 7 ms.

7. The method according to at least one of the preceding claims,
**characterized in**
**that** a capacitor (C1) is charged via a diode (D1) with the pulsating DC voltage UDC to determine the peak value U_Peak, and in that the relative value U_Rel is derived from the peak value U_Peak applied to the capacitor (C1) by means of a voltage divider (R1, R2a, R2b), wherein the voltage divider (R1, R2a, R2b) preferably has an adjustable divider ratio STV with which the relative value U_Rel is adjusted to the proportion A of the peak value U_Peak.

8. The method according to at least one of the preceding claims,
**characterized in**
**that** the EMC filter (NF) comprises a star connection of three capacitors (CX), wherein each of the capacitors (CX) is in one current path which has a first connection to one of the phase conductors (L1, L2, L3) and a second connection to a common star point (SP), and that the EMC filter (NF) comprises a capacitor (CY) which is in a current path having a first connection to a protective conductor (PE) of the multi-phase network (SN) and a second connection to the star point (SP), wherein the current paths having the capacitors (CX) or the current path having the capacitor (CY) are/is activated or deactivated by means of the switching device (SE), preferably in the form of a switching contact (SK) of a control relay (SR).

9. The method according to at least one of the preceding claims,
**characterized in**
**that** the EMC filter is a grounding capacitor of an inverter which is in the current path conducting the leakage current, having a first connection to the protective conductor (PE) of the multi-phase network (SN) and a second connection connected, such as connected or disconnected, to a terminal of an intermediate circuit of the inverter by means of the switching device (SE) in the form of a switching contact (SK) of a control relay (SR) for activation/deactivation of the current flow.

10. The method according to at least one of the preceding claims,
**characterized in**
**that** a pure AC voltage of the multi-phase network (SN) is detected by means of an AC voltage detector (WD), wherein a first signal, by means of which the asymmetry detector (AD) is activated, is generated when a pure AC voltage is applied, and wherein a second signal, by means of which the asymmetry detector (AD) is deactivated, is generated when the pure AC voltage is discontinued.

11. A switching assembly (SA) for operating an EMC filter (NF) on a multi-phase network (SN), in particular a three-phase network, having phase voltages (UL1, UL2, UL3), or in a component such as an inverter connected to the multi-phase network (SN), wherein the EMC filter (NF) has at least one current path via which a leakage current caused due to an asymmetry of the phase voltages (UL1, UL2, UL3), in particular by switching the multi-phase network (SN) on or off, flows to a protective conductor (PE) of the multi-phase network (SN), wherein the switching assembly (SA) has a measuring device (AD) designed to monitor an asymmetry of the phase voltages and to control a switching device (SE) such that the at least one current path of the EMC filter (NF) conducting the leakage current is deactivated, so that the leakage current caused by the asymmetry does not flow to the protective conductor (PE),
**characterized in**
**that** the measuring device is an asymmetry detector (AD) designed to detect an occurrence of the asymmetry, and upon occurrence of the asymmetry to generate a signal for the switching device (SE) such that the deactivation of the at least one current path of the EMC filter (NF) conducting the leakage current takes place to prevent an unintended shutdown of a residual current circuit breaker, connected upstream of the EMC filter (NF) and having a tripping time T_a, within a switch-off delay time dT_av after occurrence of the asymmetry, wherein the delay time dT av is shorter than the tripping time T_a of the residual current circuit breaker, and
**that** an activation of the current path takes place when the phase voltages (UL1, UL2, UL3) have substantially the same voltage without interruption at least over a defined switch-on delay time dT_ev.

12. The switching assembly according to claim 11,
**characterized in**
**that** the asymmetry detector (AD) comprises:
a rectifier (BG) designed to rectify the phase voltages (UL1, UL2, UL3); a peak value detector (SD) designed to detect a peak value U_Peak of the pulsating DC voltage UDC of the rectifier (BG); a momentary value detector (MD) designed to detect a momentary value MDC(t) of the pulsating DC voltage UDC of the rectifier (BG); and a comparator (K) designed to compare the momentary value UDC(t) with the peak value U_Peak, wherein an output (A1) of the comparator (K) is coupled to an input of the switching device (SE).

13. The switching assembly according to claim 11 or 12,
**characterized in**
**that** an output (AK) of the comparator (K) is coupled to an input (ZE) of a timer (ZG) whose output (ZA) is connected to an input (ET) of a trigger circuit (ST), and that an output (TA) of the trigger circuit (ST) is connected to the input (ES) of the control unit (SE), preferably via a level converter (PW).

14. The switching assembly according to at least one of claims 11 to 13,
**characterized in**
**that** the EMC filter (NF) comprises a star connection of three capacitors (CX), wherein each of the capacitors (CX) is in a current path which has a first connection to one of the phase conductors (L1, L2, L3) and a second connection to a common star point (SP), and that the EMC filter (NF) comprises a capacitor (CY) which is in a current path that has a first connection to the star point (SP) and a second connection to the protective conductor (PE), wherein the switching device (SE) is arranged in each of the current paths of the capacitors (CX) and/or in the current path of the capacitor (CY).

15. The switching assembly according to at least one of claims 11 to 14,
**characterized in**
**that** the EMC filter is a grounding capacitor of a inverter which is in the current path conducting the leakage current and has a first connection to the protective conductor of the multi-phase network (SN) and a second connection connectable to a terminal of an intermediate circuit of the inverter by means of the switching device (SE) for activation/deactivation of the current flow.

16. The switching assembly according to at least one of claims 11 to 18,
**characterized in**
**that** the switching device (SE) comprises a control relay (SR) with a switching contact (SK), wherein the switching contact (SK) is arranged in the current path of the capacitor (CY), in the current paths of the capacitors (CX) and/or in the current path of the grounding capacitor, and that the switching device (SE) preferably comprises a switching element (T) such as a transistor for operating the control relay (SR).

17. The switching assembly according to at least one of claims 11 to 16,
**characterized in**
**that** the switching assembly (SA) comprises an AC voltage detector (WD) which is designed to detect a pure AC voltage of the multi-phase network, wherein a first signal, by means of which the asymmetry detector (AD) is activated, is generated when a pure AC voltage is applied, and wherein a second signal, by means of which the asymmetry detector (AD) is deactivated, is generated when the pure AC voltage is discontinued.

18. The switching assembly according to at least one of claims 11 to 17,
**characterized in**
**that** the switching assembly (SA) is integrated in an EMC filter (NF) or in an inverter.

19. An EMC filter (NF) comprising at least one star connection of three capacitors (CX), wherein each of the capacitors (CX) is in a current path which has a first connection to a phase conductor (L1, L2, L3) of a multi-phase network (SN) and a second connection to a common star point (SP), and wherein the EMC filter (NF) comprises a capacitor (CY) which is in a current path that has a first connection to the star point (SP) and a second connection to the protective conductor (PE), wherein the switching device (SE) is arranged in each of the current paths of the capacitors (CX) and/or in the current path of the capacitors (CY) and is switchable depending on the symmetry or asymmetry of the phase voltages of the multi-phase network.

## Revendications

1. Procédé pour faire fonctionner un filtre CEM (NF, EK) sur un réseau de courant polyphasé (SN) présentant des tensions de phase (UL1, UL2, UL3), notamment un réseau de courant triphasé, ou dans un composant raccordé au réseau de courant polyphasé (SN), tel qu'un redresseur (UR), sachant que dans au moins un trajet de courant du filtre CEM, un courant de fuite s'écoulant vers un conducteur de protection (PE) du réseau de courant polyphasé (SN) en raison d'une asymétrie des tensions de phase (UL1, UL2, UL3), notamment par la mise sous tension ou hors tension du réseau de courant polyphasé (SN), sachant que l'asymétrie des tensions de phase (UL1, UL2, UL3) est surveillée au moyen d'un dispositif de mesure (AD), et sachant que ledit au moins un trajet de courant conduisant le courant de fuite du filtre CEM (NF, EK) est désactivé au moyen d'un dispositif de commutation (SE) afin que le courant de fuite causé par l'asymétrie ne puisse pas s'écouler vers le conducteur de protection (PE),
**caractérisé en ce**
**qu'**est utilisé comme dispositif de mesure, un détecteur d'asymétrie (AD), sachant que la surveillance de l'asymétrie comprend la détection d'une apparition de l'asymétrie, que la désactivation du trajet de courant pour éviter une fausse coupure d'un disjoncteur différentiel monté en amont du filtre CEM (NF, EK) et présentant un temps de déclenchement T_a a lieu au moyen du dispositif de commutation (SE) pendant un intervalle de temporisation de désactivation dT_av après l'apparition de l'asymétrie, sachant que l'intervalle de temporisation de désactivation dT_av est plus court que le temps de déclenchement T_a du disjoncteur différentiel et
**que** le trajet de courant n'est activé que lorsque les tensions de phase (UL1, UL2, UL3) présentent essentiellement la même tension, sans interruption, au moins pendant un intervalle de temporisation de mise sous tension dT_ev.

2. Procédé selon la revendication 1,
**caractérisé en ce**
**que** l'intervalle de temporisation de mise sous tension dT_ev est réglé au moyen d'un temporisateur (ZG) sur une durée telle que 600 ms ≤ dT_ev ≤ 1000 ms, de préférence dT_ev = 800 ms et/ou que l'intervalle de temporisation de désactivation dT_av est réglé au moyen du temporisateur (ZG) sur une durée telle que 0,3 ms ≤ dT_av ≤ 0,7 ms, de préférence dT_av = 0,5 ms.

3. Procédé selon la revendication 1 ou 2,
**caractérisé en ce**
**que** l'asymétrie des tensions de phase (UL1, UL2, UL3) est détectée par l'analyse d'une tension continue pulsée UDC, produite par le redressement des tensions de phase (UL1, UL2, UL3) au moyen d'un redresseur (BG), sachant qu'une valeur momentanée UDC(t) de la tension continue pulsée UDC est acquise au moyen d'un détecteur de valeur momentanée (MD), sachant qu'une valeur de pointe U_Peak de la tension continue pulsée UDC est déterminée, et sachant que la valeur momentanée UDC(t) est comparée à la valeur de pointe U_Peak au moyen d'un comparateur (K) et sachant qu'ensuite, quand la valeur momentanée UDC(t) dépasse une fois une valeur relative U_Rel prédéfinie, un signal de détection DS affichant l'asymétrie est généré pour la commande du dispositif de commutation (SE).

4. Procédé selon au moins l'une des revendications précédentes,
**caractérisé en ce**
**que** la valeur relative U_Rel est une fraction A de la valeur de pointe U_Peak, avec U_Rel = A x U_Peak, sachant que A se situe dans la plage telle que 0,7 ≤ A ≤ 0,8, de préférence A = 0,75.

5. Procédé selon au moins l'une des revendications précédentes,
**caractérisé en ce**
**que** le signal de détection DS est généré en cas de coupure d'une tension de phase (UL1, UL2, UL3) ou périodiquement lors de l'apparition d'une sous-tension d'une tension de phase (UL1, UL2, UL3) de par ex. 20 % par rapport à une tension de consigne et/ou que le signal de détection DS est généré au cours d'un intervalle de temporisation de détection dT_dv après l'apparition de l'asymétrie, sachant que l'intervalle de temporisation de détection dT_dv se situe sur la plage telle que 0 ms ≤ dT_dv ≤ dT_dvmax, sachant que la durée de temporisation de détection maximale dT_dvmax est déterminée par le facteur A et se situe, pour un facteur A dans la plage telle que 0,75 ≤ A ≤ 0,8, dans la plage 3 ms ≤ dT dvmax ≤ 4 ms et est de préférence dT_dvmax = 4 ms avec A = 0,75.

6. Procédé selon au moins l'une des revendications précédentes,
**caractérisé en ce**
**qu'**est utilisé comme dispositif de commutation (SE) un relais de commutation (SR) avec un délai de réaction T_r tel que 0 ms ≤ T_r ≤ 2,5 ms et/ou
**que** le délai de temporisation de désactivation dT_av résulte d'une somme de l'intervalle de temporisation de détection dT_dv du détecteur d'asymétrie (AD), d'un intervalle de temporisation dT_off du temporisateur (ZG) et du délai de réaction T_r du relais de commutation (SR) et se situe de préférence dans la plage telle que 0 ms ≤ dT_av ≤ dT_avmax, sachant que dT_avmax = dT_dvmax + dT_off + T_r = 4 ms + 0,5 ms + 2,5 ms = 7 ms.

7. Procédé selon au moins l'une des revendications précédentes,
**caractérisé en ce**
**que** pour déterminer la valeur de pointe U_Peak, un condensateur (C1) est chargé avec la tension continue pulsée UDC via une diode (D1), que la valeur relative U_Rel est déduite de la valeur de pointe U_Peak présente sur le condensateur (C1) au moyen d'un diviseur de tension (R1, R2a, R2b), sachant que le diviseur de tension (R1, R2a, R2b) présente, de préférence, un rapport de division STV réglable avec lequel la valeur relative U_Rel est réglée sur la fraction A de la valeur de pointe U_Peak.

8. Procédé selon au moins l'une des revendications précédentes,
**caractérisé en ce**
**que** le filtre CEM (NF) comprend un montage en étoile composé de trois condensateurs (CX), sachant que chacun des condensateurs (CX) se situe dans un trajet de courant qui est relié à un des conducteurs de phase (L1, L2, L3) avec un premier raccord et à un point neutre commun (SP) avec un second raccord et que le filtre CEM (NF) comprend un condensateur (CY) qui se situe dans un trajet de courant dont le premier raccord est relié à un conducteur de protection (PE) du réseau de courant polyphasé (SN) et dont le second raccord est relié au point neutre (SP), sachant que les trajets de courant présentant les condensateurs (CX) ou que le trajet de courant présentant le condensateur (CY) est activé ou désactivé au moyen du dispositif de commutation (SE) de préférence sous la forme d'un contact de commutation (SK) d'un relais de commande (SR).

9. Procédé selon au moins l'une des revendications précédentes,
**caractérisé en ce**
**que** le filtre CEM est un condensateur de mise à la terre d'un redresseur, qui se trouve dans le trajet de courant conduisant le courant de fuite et dont le premier raccord est relié au conducteur de protection (PE) du réseau de courant polyphasé (SN) et dont le second raccord est câblé, tel que relié ou séparé, à un pôle d'un circuit intermédiaire du redresseur, au moyen du dispositif de commutation (SE) sous forme de contact de commutation (SK) d'un relais de commande (SR).

10. Procédé selon au moins l'une des revendications précédentes,
**caractérisé en ce**
**qu'**au moyen d'un détecteur de tension alternative (WD), une tension alternative du réseau de courant polyphasé (SN) est détectée, sachant qu'en cas de présence d'une tension alternative pure, un premier signal est généré au moyen duquel le détecteur d'asymétrie (AD) est activé et sachant qu'en cas de disparition de la tension alternative pure, un second signal est généré au moyen duquel le détecteur d'asymétrie (AD) est désactivé.

11. Système de commutation (SA) pour exploiter un filtre CEM (NF) sur un réseau de courant polyphasé (SN) présentant des tensions de phase (UL1, UL2, UL3), notamment un réseau de courant triphasé, ou dans un composant raccordé au réseau de courant polyphasé (SN), tel qu'un redresseur, sachant que le filtre CEM (NF) présente au moins un trajet de courant le long duquel un courant de fuite causé en raison de l'asymétrie des tensions de phase (UL1, UL2, UL3), notamment par la mise sous ou hors tension du réseau de courant polyphasé (SN) s'écoule vers un conducteur de protection (PE) du réseau de courant polyphasé (SN), sachant que le système de commutation (SA) présente un dispositif de mesure (AD) qui est conçu pour surveiller une asymétrie des tensions de phase et pour commander un dispositif de commutation (SE) de telle sorte que ledit au moins un trajet de courant conduisant le courant de fuite du filtre CEM (NF) est désactivé afin que le courant de fuite causé par l'asymétrie ne s'écoule pas vers le conducteur de protection (PE),
**caractérisé en ce**
**que** le dispositif de mesure est un détecteur d'asymétrie (AD) qui est conçu pour détecter une apparition de l'asymétrie, et pour générer un signal pour le dispositif de commutation (SE) à l'apparition de l'asymétrie de sorte que la désactivation dudit au moins un trajet de courant conduisant le courant de fuite du filtre CEM (NF) pour éviter une fausse coupure d'un disjoncteur différentiel monté en amont du filtre CEM (NF) et présentant un temps de déclenchement T_a a lieu pendant un intervalle de temporisation de désactivation dT_av après l'apparition de l'asymétrie, sachant que le laps de temps dT_av est plus court que le temps de déclenchement T_a du disjoncteur différentiel et
**qu'**une activation du trajet de courant a lieu lorsque les tensions de phase (UL1, UL2, UL3) présentent essentiellement la même tension, sans interruption, au moins pendant un intervalle de temporisation de mise sous tension dT_ev défini.

12. système de commutation selon la revendication 11,
**caractérisé en ce**
**que** le détecteur d'asymétrie (AD) comprend :
un redresseur (BG) qui est conçu pour redresser les tensions de phase (UL1, UL2, UL3), un détecteur de valeur de pointe (SD) qui est conçu pour acquérir une valeur de pointe U_Peak de la tension continue pulsée UDC du redresseur (BG), un détecteur de valeur momentanée (MD) qui est conçu pour acquérir une valeur momentanée MDC(t) de la tension continue pulsée UDC du redresseur (BG), un comparateur (K) qui est conçu pour comparer la valeur momentanée UDC(t) à la valeur de pointe U Peak, sachant qu'une sortie (A1) du comparateur (K) est couplée à une entrée du dispositif de commutation (SE).

13. Système de commutation selon la revendication 11 ou 12,
**caractérisé en ce**
**qu'**une sortie (AK) du comparateur (K) est couplée à une entrée (ZE) d'un temporisateur (ZG), dont la sortie (ZA) est reliée à une entrée (ET) d'un circuit de déclenchement (ST) et qu'une sortie (TA) du circuit de déclenchement (ST) est reliée à l'entrée (ES) de l'unité de commande (SE) de préférence via un convertisseur de niveau (PW).

14. Système de commutation selon au moins l'une des revendications 11 à 13,
**caractérisé en ce**
**que** le filtre CEM (NF) comprend un montage en étoile composé de trois condensateurs (CX), sachant que chacun des condensateurs (CX) se situe dans un trajet de courant qui est relié à un des conducteurs de phase (L1, L2, L3) avec un premier raccord et à un point neutre commun (SP) avec un second raccord et que le filtre CEM (NF) comprend un condensateur (CY) qui se situe dans un trajet de courant qui se situe au point neutre (SP) avec un premier raccord et au conducteur de protection (PE) avec un second raccord, sachant que le dispositif de commutation (SE) est disposé dans, respectivement, un des trajets de courant des condensateurs (CX) et/ou dans le trajet de courant du condensateur (CY).

15. Système de commutation selon au moins l'une des revendications 11 à 14,
**caractérisé en ce**
**que** le filtre CEM est un condensateur de mise à la terre d'un redresseur, qui se trouve dans le trajet de courant conduisant le courant de fuite et qui est relié au conducteur de protection (PE) du réseau de courant polyphasé (SN) avec un premier raccord et dont le second raccord peut être câblé à un pôle d'un circuit intermédiaire du redresseur, au moyen du dispositif de commutation (SE) pour l'activation/la désactivation du trajet de courant.

16. Système de commutation selon au moins l'une des revendications 11 à 18,
**caractérisé en ce**
**que** le dispositif de commutation (SE) comprend un relais de commande (SR) avec un contact de commutation (SK), sachant que le contact de commutation (SK) est disposé dans le trajet de courant du condensateur (CY), les trajets de courant des condensateurs (CX) et/ou le trajet de courant du condensateur de mise à la terre et que le dispositif de commutation (SE) comprend de préférence un élément de commutation (T), tel qu'un transistor, pour l'excitation du relais de commande (SR).

17. Système de commutation selon au moins l'une des revendications 11 à 16,
**caractérisé en ce**
**que** le système de commutation (SA) comprend un détecteur de tension alternative (WD) qui est conçu pour détecter une tension alternative pure du réseau de courant polyphasé, sachant qu'en cas de présence d'une tension alternative pure, un premier signal est généré au moyen duquel le détecteur d'asymétrie (AD) est activé et sachant qu'en cas de disparition de la tension alternative pure, un second signal est généré au moyen duquel le détecteur d'asymétrie (AD) est désactivé.

18. Système de commutation selon au moins l'une des revendications 11 à 17,
**caractérisé en ce**
**que** le système de commutation (SA) est intégré dans un filtre CEM (NF) ou dans un redresseur.

19. Filtre CEM (NF) comprenant au moins un montage en étoile composé de trois condensateurs (CX), sachant que chacun des condensateurs (CX) se situe dans un trajet de courant qui est relié à un conducteur de phase (L1, L2, L3) d'un réseau polyphasé avec un premier raccord et à un point neutre commun (SP) avec un second raccord et que le filtre CEM (NF) comprend un condensateur (CY) qui se situe dans un trajet de courant qui se situe au point neutre (SP) avec un premier raccord et au conducteur de protection (PE) avec un second raccord, sachant que le dispositif de commutation (SE) est disposé dans, respectivement, un des trajets de courant des condensateurs (CX) et/ou dans le trajet de courant du condensateur (CY) et est commutable selon la symétrie ou l'asymétrie des tensions de phase du réseau de courant polyphasé.
